# EUROPÄISCHE PATENTANMELDUNG

(11) **EP 0 658 068 A2**
(43) Veröffentlichungstag der Anmeldung: **14.06.1995**
(21) Anmeldenummer: 94119289.0
(22) Anmeldetag: 07.12.1994
(51) Int. Cl.: H05B 6/06, G01R 19/00

(54) **Vorrichtung zum Überwachen von Spulen**

(30) Priorität: 08.12.1993 US 162997
(71) Anmelder: TOCCO, INC., Boaz Alabama 35957 (US)
(72) Erfinder: Griebel, Arthur H., Troy, Michigan 48098 (US)
(74) Vertreter: Hennicke, Albrecht, Dipl.-Ing.

(57) **Zusammenfassung**

Die Erfindung betrifft eine Überwachungsvorrichtung (CM) zum Erzeugen eines Stromsignals mit einer Spannung, die ein Maß für den momentanen Wechselstrom in einer Induktionsheizspule (30) darstellt, die mit einer Wechselstromversorgung (12,14) über zwei in geringem Abstand voneinander angeordnete, parallele eingangsleitungen (32,34) verbunden ist, die von einem engen Spalt (36) oder Fluxdurchlaß voneinander getrennt sind, durch den ein Flux (F) fließt, der von dem Wechselstrom in den Leitungen (32,34) erzeugt wird. Erfindungsgemäß weist die Überwachungsvorrichtung eine Abtastwicklung (100) mit mehreren Windungen auf, die mit Befestigungsmitteln (362,372) Zwischen den beiden parallelen Leitungen und über dem Fluxdurchlaß befestigt ist, wobei der durch den Fluxdurchlaß fließende Fluß die Windungen der Abtastwicklung (100) kreuzt oder durch diese hindurchgeht. Die Überwachungsvorrichtung (CM) weist außerdem eine Einrichtung zum Erzeugen des Stromsignals durch die in der Abtastwicklung induzierte Spannung auf.

## Beschreibung

Die Erfindung liegt auf dem Gebiet des Induktionsheizens und betrifft insbesondere eine Spulen-Überwachungsvorrichtung zum Überwachen des an einer Induktionsheizspule während eines Arbeitstaktes anliegenden Stromes. Induktionsheizanlagen werden im allgemeinen zum Härten, Anlassen, Vergüten o.dgl. von länglichen Werkstücken verwendet.

Aus der US-3 746 825 (Pfaffmann) ist eine Vorrichtung und ein Verfahren zum Messen der Eingangsenergie für eine Induktionsheizspule bekannt, womit die Spannung und der Strom der Spule gemessen und die gemessenen Werte miteinander verknüpft werden. Mit dieser bekannten Vorrichtung wird eine Energie-Kontrolleinrichtung geschaffen, die dazu geeignet ist, den Heizzyklus einer Induktions-Heizungsanordnung zu steuern oder zu regeln. Das bekannte Verfahren und die bekannte Vorrichtung sind auf eine Anordnung gerichtet, bei der der Strom in der Induktions-heizspule von einem Stromumformer gemessen wird, der um eine Kabelverbindung oder eine Vielfachleitung gewickelt ist, die von einer Betriebsstation oder einem Transformator zu der Induktivitätsspule verläuft. Die in dieser bekannten Druckschrift beschriebene Vorrichtung und das Verfahren bildet den Hintergrund der vorliegenden Erfindung. Der dort beschriebene Stand der Technik wird hier als Hintergrundinformation zum Offenbarungsgehalt der vorliegenden Erfindung gemacht.

Beim Induktionsheizen ist es seit langem bekannt, daß der Heizbetrieb verhältnismäßig einfach dadurch gesteuert oder geregelt werden kann, daß während eines Heiztaktes die Spulenspannung und der Spulenstrom gemessen wird, der von einem hochfrequenten, durch die Induktionsheizspalte geleiteten Wechselstrom erzeugt wird. Ein Hauptziel derartiger Anordnungen liegt darin, die Spannung und den Strom in unmittelbarer Nähe der Induktionsheizspule zu messen, was jedoch Schwierigkeiten mit sich bringt. Wenn bei den bekannten Vorrichtungen der Strom über eine Abzweigung oder einen Nebenwiderstand (shunt) gemessen wird, ist es erforderlich, daß der zur Spule führende Eingangsleiter unterbrochen wird. Wie bei dem vorgenannten Patent wird im allgemeinen ein Stromumformer verwendet, der vergleichsweise groß ist und um einen der Eingangsleiter oder - busse herum angeordnet sein muß. Aus den genannten Gründen ist zwar versucht worden, den Strom an der Spule selbst zu überwachen, diese Versuche sind jedoch nicht besonders erfolgreich oder praktikabel gewesen. Darüberhinaus sind die bekannten Vorrichtungen und Verfahren zum Überwachen des Stroms und der Spannung einer Heizspule sehr komplex aufgebaut und erfordern Rückkopplungsverfahren, die bei einer Vielzahl von Induktionsheizungsvorrichtungen nicht zweckmäßig anzuwenden sind.

Die vorliegende Erfindung betrifft eine Spulenüberwachungsvorrichtung zum Erzeugen eines Stromsignals mit einer Spannung, die ein Maß für den Momentan-Wechselstrom in der Induktionsheizspule ist.

Diese neue Spulenüberwachungsvorrichtung kann zweckmäßig auch eine Einrichtung zum Spannungsabgriff aufweisen, so daß die Überwachungsvorrichtung sowohl ein Spannungssignal erzeugt, das ein Maß für den Wechselstrom in der Induktionsheizspule ist als auch ein Spannungssignal erzeugen kann, das mit der momentanen Spannung übereinstimmt, die an der Spule anliegt. Mit der Erfindung können die momentanen Werte von Strom und Spannung miteinander verknüpft werden, um eine große Anzahl von Kenngrößen zu erzeugen bzw. zu errechnen wie beispielsweise Leistung, Strom, Spannung, Phasenwinkel, Wechselstromwiderstand (Impedanz), Frequenz, Heizzeit oder andere Meßgrößen.

Nach der Erfindung weist die Spulenüberwachungsvorrichtung eine Abtastwicklung mit mehreren Windungen auf und ist mit Befestigungsmitteln versehen, mit deren Hilfe die Abtastwicklung zwischen den parallel zur Induktionsheizspule verlaufenden Eingangsleitungen und oberhalb des dazwischen befindlichen Spaltes gehaltert wird, so daß der durch diesen Spalt fließende Fluß (flux) die Windungen der Abtastwicklung kreuzt oder durch diese hindurchgeht und so eine Spannung in der Abtastwicklung erzeugt oder induziert, die eine Funktion von dem Strom und der Frequenz in der Induktionsheizspule ist. Die Spulenüberwachungsvorrichtung weist auch eine Einrichtung zum Erzeugen des Stromsignals aufgrund der in der Abtastwicklung induzierten Spannung auf, wobei die Abtastwicklung an einer Stelle zwischen den Eingangsleitungen oder -bussen der Spule und in dem engen Spalt angeordnet ist, der zu der Induktionsheizspule führt.

Die Spulenüberwachungsvorrichtung nach der Erfindung weist Abtastmittel zum Ermitteln der zeitlichen Änderung des Flusses auf, der im Spalt Zwischen den eng voneinander beabstandeten, parallelen Eingangsbussen fließt, die mit der Induktionsheizspule verbunden sind. Diese Eingangsbusse oder -leitungen werden häufig auch als "Fischschwänze" (fishtails) oder Fischflossen bezeichnet. Die Überwachungsvorrichtung weist Mittel auf, die auf die Stromfühleinrichtung ansprechen und ein Spannungssignal erzeugen, das von der Größe und der Frequenz des Wechselstroms abhängt, der durch die Induktionsheizspule fließt. Die Vorrichtung hat darüber hinaus Mittel, die den Frequenzanteil oder die Frequenzfunktion von dem Spannungssignal abtrennen, um ein neues Spannungssignal zu erzeugen, das eine Funktion der Größe des Stromes ist, der durch die Induktionsheizspule fließt. Nach der Erfindung hängt die in der Abtasteinrichtung bzw. -wicklung induzierte Spannung von der Frequenz ab und ist um 90° phasenverschoben. Zum Erzeugen eines Spannungssignals, das ein Maß für den durch die Induktionsheizspule fließenden Strom ist, ist weiter ein üblicher Low-Pass-Filter vorgesehen, der im höheren Frequenzbereich betrieben wird, der durch die Abfall-Charakteristika (roll-over characteristic) des Filters definiert ist. Hierdurch wird es möglich, daß die von der Abtastwicklung gelieferte Spannung eine geradlinige Funktion der Frequenz ist, also direkt zu dieser proportional ist, wobei der Spannungswert mit steigender Frequenz ansteigt. Umgekehrt verringert sich die Abfall-Frequenz (roll-off frequency) des Low-Pass-Filters in einer geradlinigen Funktion bei steigender Frequenz. Wenn das Spannungssignal von der Abtastwicklung durch den Low-Pass-Filter geleitet wird, zeigt das Signal für die Momentanspannung den durch die Induktionsheizspule fließenden Momentanstrom an. Die Spannung kann nicht als absoluter Spannungswert abgelesen werden, aber ihre Höhe ist ein Maß für einen bestimmten Stromfluß. Das Stromsignal von der Spulenüberwachungsvorrichtung verändert sich so zusammen mit dem tatsächlich durch die Spule fließenden Strom. Das Ausgangsspannungssignal, das den Strom in der Spulenüberwachungsvorrichtung darstellt, kann erfindungsgemäß mit Hilfe einer Widerstandsschaltung o.dgl. verkleinert werden, um die erwünschte Stromdarstellung für ein gegebenes Verfahren zu erzielen. Auf diese Weise ist die Spannung des Stromsignales eine Funktion des Momentanstromes oberhalb und unterhalb einer voreingestellten, skalierten Spannung, die einen bestimmten, aber unbekannten Stromfluß anzeigt. Mit der Erfindung wird also ein Spannungsniveau oder - signal erzeugt, das den Momentanstrom anzeigt, der durch die Induktionsheizspule fließt. Es ist nicht erforderlich, zum Überwachen des Prozesses die absolute Größe des Stroms zu kennen. Die Strompegel oder Stromsignale können dazu verwendet werden, ein Leistungs- oder kW-Signal und andere Signale zu erzeugen, die andere, der Stromstärke verwandte Kennwerte darstellen. Das den Strom durch die Induktionsheizspule darstellende Spannungssignal kann also in den verschiedensten graphischen Darstellungen, Anzeigeeinrichtungen, Kennsignalanalyseeinrichtungen o.dgl. ausgewertet und weiterverarbeitet werden. Das gleiche gilt auch für mit dem Strom verwandte Kenngrößen wie beispielsweise die Leistung und den Phasenwinkel.

Aufgabe der Erfindung ist es, eine Vorrichtung zum Überwachen des Stroms in einer Induktionsheizspule während eines Induktionsheiztaktes oder eines Testzyklus zu schaffen, die ein Spannungssignal erzeugt, das ein Anzeichen oder ein Maß für den Momentanstrom in der Induktionsheizspule ist.

In bevorzugter Ausgestaltung der Erfindung wird eine Spulenüberwachungsvorrichtung der oben angegebenen Art geschaffen, die leicht an bestehenden Induktionsheizanlagen angebracht und von diesen auch wieder entfernt werden kann.

Mit der Erfindung wird in bevorzugter Ausgestaltung weiterhin eine Überwachungsvorrichtung geschaffen, die dazu verwendet werden kann, eine gleichbleibende Leistung an der Spule, einen gleichbleibenden Spulenstrom und gleichbleibende Spulenspannung sowie gleichbleibende Impedanz an der Spule und Heizzeit nachzumessen bzw. sicherzustellen. Außerdem können mit der erfindungsgemäßen Vorrichtung der Zustand des erwärmten Werkstücks bzw. Teilen hiervon, seine Abmessungen sowie die Anordnung des Werkstücks in der Spule überwacht oder festgestellt werden.

Ein weiteres Ziel der Erfindung ist es, eine Spulenüberwachungsvorrichtung der oben genannten Art zu schaffen, mit der es möglich ist, einen Bund o.dgl. an einem Werkstück festzustellen, indem die Phasenwinkel und andere elektrische Kennwerte überwacht werden. Mit der Erfindung können auch Durchmesseränderungen eines abgetasteten Bauteils und das Ende des Bauteils festgestellt werden und das Härten, Anlassen, Vergüten o.dgl. des bearbeiteten Werkstücks gemessen bzw. überwacht werden.

Mit der Erfindung kann die Hochfrequenzenergie einer Induktionsheizspule überwacht werden; die Erfindung hat jedoch darüberhinaus gehende Anwendungsbereiche und kann bei zusammenwirkenden, interaktiven und interproaktiven Induktionsheizprozessen verwendet werden.

Die phasengleiche Spannung und der Strom für eine Induktionsheizspule können gemessen werden, indem ein Spannungssignal erzeugt wird, das den momentaren Strom in der Induktionsheizspule anzeigt. Spannung und Strom können für eine Anzeigevorrichtung, zum Erzeugen von Liniendiagrammen, eine computerbetätigte Systemsteuerung bzw. -regelung und zur Kennsignalanalyse (signature analysis) verwendet werden. Nach der Erfindung kann die Überwachungsvorrichtung an verschiedene Frequenzen angepaßt werden bzw. sich selbst anpassen, die infolge von Anpassungsänderungen zwischen Spule und Bauteil und von Schwankungen in der Stromversorgungsfrequenz auftreten, die durch die empfindlichen Regel- bzw. Steuereigenschaften der Stromversorgung angeregt werden. Die erfindungsgemäße Anordnung verwendet ein die Frequenz kompensierendes Meßschema, wobei die Frequenzkomponente oder die Funktion des Stromes dadurch verdrängt wird, daß das die Frequenzfunktion einschließende, momentane Spannungssignal durch einen im Abfallbereich (roll-off area) betriebenen Low-Pass-Filter geleitet wird, der eine reziproke Frequenzfunktion hat.

Die erfindungsgemäße Vorrichtung spricht auf dynamische Veränderungen in dem erhitzen Bauteil sehr gut an. Derartige Veränderungen können die Oberflächentemperatur und/oder den Temperaturverlauf betreffen oder auch die Eindringtiefe des Stromflusses in das Werkstück und andere vom Strom beeinflußte Werkstückkennwerte. Die Anordnung nach der Erfindung arbeitet ähnlich, wie dies aus der Wirbelstromtechnik bekannt ist; sie reagiert jedoch wesentlich empfindlicher auf den momentanen Zustand im Werkstück, da die erfindungsgemäße Spulenüberwachungsvorrichtung dynamische Veränderungen auch in größerer Tiefe am Werkstück messen kann. Mit der erfindungsgemäßen Überwachungsvorrichtung kann der gesamte Leistungsbereich der Heizstromversorgung genutzt werden. Auch ist die logische Schaltung des verwendeten Mikroprozessors besonders flexibel, der dazu dient, die abgetasteten, von der Spulenüberwachungsvorrichtung erzeugten Daten zu verarbeiten.

Mit der Erfindung wird ein Ausgangssignal erzeugt, das auf Veränderungen der Umgebungstemperatur des Werkstücks anspricht; demgemäß kann eine Anordnung, die von der Erfindung Gebrauch macht, die Rotation des jeweiligen Werkstücks, seine mögliche Exzentrizität, geometrische Form und Formänderungen sowie weitere Relativpositionen innerhalb der Induktionsheizspule feststellen. Darüberhinaus können mit einer solchen Anordnung auch Temperaturunterschiede im Bauteil festgestellt werden.

Ein System, das von der erfindungsgemäßen Spulenüberwachungsvorrichtung Gebrauch macht, kann eine Reihe verschiedener Kennungszahlen für einen Kennsignal-Analyse-Schaltkreis erzeugen, wobei die Kennungssignale von dem speziellen, überwachten Kennwert abhängen, wie z.B. vom Strom, der Spannung, der Frequenzverschiebung, der Phasenänderung oder irgendeinem anderen Kennwert, der durch Verknüpfen der Ausgangsphasenspannung (end phase voltage) und dem durch die Induktionsheizspule fließenden Momentanstromes erzeugt werden kann. Nach einem anderen Aspekt der Erfindung können auch mehr als ein Kennwert in einer Kennsignal-Analyseeinrichtung verarbeitet werden, wodurch ein kombiniertes Kennsignal-Analyse-System entsteht.

Mit der Erfindung kann eine neuartig aufgebaute Spulenüberwachungsvorrichtung bei bestimmten Einrichtungen eingesetzt werden, die dazu verwendet werden, das Vorhandensein eines Werkstücks oder Bauteils, eine Exzentrizität des Bauteils, die Ausrichtung eines bestimmten Teils des Werkstücks in Bezug auf die Spule festzustellen und/oder den Wärmebehandlungszustand, die Größe und die Lage des Bauteils zu überprüfen und Ausschußteile zu ermitteln. Die erfindungsgemäße Vorrichtung kann Wirbelstromeinrichtungen für die zerstörungsfreie Werkstückprüfung ersetzen.

Mit der Erfindung ist es durch Überwachen der Impedanz oder des Wechselstromwiderstands möglich, vorstehende Ränder, Flansche o.dgl. am Werkstück zu lokalisieren, und zwar so, daß es damit möglich ist, die Größenabweichungen des Bauteils auszugleichen, wobei ein gleichbleibender Kuppelabstand von dem Rand eingehalten wird, um den Heizzyklus zu starten. Mit der Erfindung können auch Durchmesseränderungen des Werkstücks durch Veränderungen der Impedanz festgestellt werden. Die Impedanz hängt von der abgetasteten Spannung und dem abgetasteten Strom ab. Mit der Erfindung kann das Ende eines abgetasteten Bauteils durch Überwachen der Impedanz festgestellt werden. Bei Verwendung der Erfindung kann das Endstück eines länglichen Bauteils gehärtet werden, ohne daß es überhitzt wird. Schwankungen in der Werkstücklänge, die infolge der üblichen Wärmeausdehnung beim induktiven Erhitzen auftreten, werden somit ausgeglichen und haben auf die Qualität des Härtens keinen Einfluß.

Die erfindungsgemäße Einrichtung kann dazu verwendet werden, die Abtastgeschwindigkeit oder Relativgeschwindigkeit zwischen Werkstück und Spule zu steuern bzw. zu regeln, indem die Spulenimpedanz beim Abtasten des Werkstücks konstant gehalten wird. Die Heizzeit oder der Heizzyklus für ein Bauteil oder ein Werkstück wird dadurch geregelt, daß die erfindungsgemäß überwachte Energie oder Impedanz konstant gehalten wird. Die Achsausrichtung der Spule wird sichergestellt, indem die Leistung an Werkstückbereichen abgedämpft wird, die gegenüber von solchen Bauteilbereichen liegen, die auskragen oder auslaufen. Dieses Auskragen wird von einer Einrichtung überwacht, die von der Erfindung Gebrauch macht. Das Auskragen (run-out) des Werkstücks wird mit der Erfindung festgestellt, indem Änderungen in der Leistung und/oder der Impedanz aufgezeichnet oder abgelesen werden.

Es ist mit der Erfindung auch möglich, die Zufuhr von Abschreckflüssigkeit beim Härten eines Werkstücks zu steuern. Der von der Spulenüberwachungsvorrichtung festgestellte Spulenwiderstand bzw. die Impedanz wird dazu benutzt, eine bestimmte Werkstücktemperatur festzustellen, die dann mit einer Referenztemperatur verglichen wird, um festzustellen, wann der Abschreckzyklus beim Härten eines Werkstücks begonnen werden kann.

Die Erfindung ist insbesondere zum Erhitzen und/oder Härten von Bolzen oder Barren geeignet, wobei die Leistung geregelt bzw. gesteuert wird, um die Spulenimpedanz konstant zu halten, die von der Spulenüberwachungsvorrichtung nach der Erfindung bestimmt wird.

In bevorzugter Ausgestaltung der Erfindung wird die Induktionsheizspule zum Härten einer Steckachse oder eines Radnabenzapfens in der Nähe einer Auskehlung am Achsflanschteil positioniert und die von der Spulenüberwachungsvorrichtung festgestellte Spulenimpedanz wird ausgewertet, um die richtige Startposition der Induktionsheizspule vor dem Zonenhärten bzw. dem Abtasthärten zu bestimmen. Die Spule wird dann relativ bis zum Ende des zu härtenden Achszapfens verfahren. Das Härten wird in dem Moment beendet, in dem die Impedanz sich z.B. am Achsende verändert, was von der Spulenüberwachungsvorrichtung festgestellt wird.

Die erfindungsgemäße Spulenüberwachungsvorrichtung kontrolliert den Fluß oder Flux an der Spule, korrigiert den Strom aufgrund von Frequenzänderungen im Flux und liefert ein Spannungsausgangssignal in einer Höhe, die ein Maß für eine Stromstärke ist. Diese Spannung ist ein Ausgangssignal, das zum Regeln der Stromversorgungseinrichtung und zum Anzeigen der oben bereits beschriebenen Kennwerte verwendet wird. Hierzu kann das den Induktionsspulenheizstrom darstellende Spannungssignal mit einem Signal verknüpft werden, das die von der Überwachungseinrichtung abgegriffene Spannung anzeigt, um irgendeinen von verschiedenen ausgezeichneten Parametern zu erzeugen. Diese Parameter oder Kennwerte können jeder für sich oder zu mehreren dazu verwendet werden, bestimmte Verfahrensmerkmale oder - abläufe zu bestimmen, die aufgezeichnet und überwacht und/oder für die Kennungssignalanalyse oder anderweitig bei der Prozessüberwachung der Induktionsheizanlage verwendet werden können.

Erfindungsgemäß wird der Strom in der Induktionsheizspule dadurch festgestellt, daß eine Drahtwicklung in der Nähe des Spaltes oder Schlitzes angeordnet wird, der sich zwischen den beiden Leiterhälften oder den Vielfachleitungen befindet, die zur Induktionsheizspule führen. Der von dem in den Leitungen fließenden Strom erzeugte Flux tritt durch den Spalt hindurch und kreuzt die Wicklung, die auch als Influenz- oder Eigenkapazitätsspule bezeichnet werden kann. Die in der Wicklung induzierte Spannung stellt eine maßstäbliche Messung des Stromes in den Vielfachleitungen dar. Die nah angeordnete Aufnahmewicklung erstreckt sich erfindungsgemäß im rechten Winkel über den Spalt oder Schlitz und seitlich an den Vielfachleitern nach unten, um eine möglichst große Menge magnetischen Fluxes aufzunehmen, der von dem Schlitz oder Spalt auf einer Länge von einem Zentimeter ausgeht. Der Aufnahmedraht oder die -spule ist auf einem G10-Profil aufgewickelt, das eng über die beiden Leitungen oder Busse paßt. Die in der Abtastspule oder -wicklung induzierte Spannung hängt von der Geometrie der Leitungen, dem darin fließenden Strom, der Anzahl von Windungen in der Abtastwicklung und der Stromfrequenz ab. Bei vorgegebener Abtastspule, d.h. festgelegter Windungszahl der Abtastwicklung und festliegender Leitungsgeometrie variiert die Strommessung für die Abtastwicklung mit der Frequenz und der Stärke des Stromes, der durch die Induktionsheizspule fließt. Beispielsweise wird ein Strom von 100 A in der Induktionsheizspule eine dreimal höhere Spannung in der Abtastwicklung induzieren, wenn die Spule mit einer Frequenz von 3 kHz betrieben wird, als wenn die Spule mit 1 kHz betrieben wird. Die erfindungsgemäß aufgebaute Spulenüberwachungsvorrichtung weist eine besondere Schaltung in Form eines Filters auf, um den Frequenzeinfluß auf das in der Abtastwicklung induzierte Spannungssignal zu korrigieren. Dieser Filter korrigiert das Spannungssignal von der Abtastwicklung dahingehend, daß bei einer Stromstärke von 100 A und einer Stromfrequenz von 1 kHz in der Heizspule eine gleich große Spannung von der Überwachungsvorrichtung erzeugt wird wie bei einer Stromstärke von 100 A bei einer Frequenz von 3 kHz.

Die Verwendung der Nahfeldspule (proximity coil) oder Abtastwicklung und die Ausschaltung der Frequenzfunktion bzw. - komponente im Spannungssignal zum Erzeugen eines Spannungspegels als Maß für ein Stromniveau in einer Induktionsheizspule ist neu. Diese besondere Stromabtastanordnung für eine Induktionsheizspule erlaubt es, eine große Anzahl von eigenen Kennwerten zu bilden, um die verschiedenen, bislang beschriebenen Systemregelungen und -Steuerungen zu ermöglichen. Die Spulenüberwachungsvorrichtung mißt auch die phasengleiche Spannung (in-phase voltage), indem ein kleiner Signalumformer mit seiner Primärseite an die beiden Leitungen der Induktionsheizspule angeschlossen ist. Die Sekundärwicklung des Umformers ist Bestandteil der Spulenüberwachungsvorrichtung und ist auf einem isolierten Spulenkörper aufgewickelt, wobei eine etwa 0,8mm dicke (1/32 in) Nylonisolierung die Primär- von der Sekundärwicklung zur Spannungsisolation abtrennt. Der Umformer in dem Gehäuse für die Überwachungsvorrichtung bewirkt eine Spannungsumwandlung im Verhältnis von 5:1. Für das Audio-Frequenz-Induktionsheizen mit Frequenzen unterhalb etwa 10 Khz hat sich dieses Verhältnis als geeignet erwiesen.

In vorteilhafter Ausgestaltung der Erfindung sind die Abtastwicklung und der Spannungsumwandler in einem Gehäuse aus G10 Kunststoff (Laminat) angeordnet. Dieses Gehäuse weist eine kompakte Dichteinheit auf, die zur vollständigen Isolation und zum Schutz vor Wasser mit einem elektrischen Harz ausgegossen ist. Das Gehäuse selbst weist einen Schlitz auf, in den die beiden Leitungen oder Vielfachleiter eingeführt werden können, und ist mit vier Schrauben versehen, die das Gehäuse fest an den Leitungen in der Nähe der Heizspule arretieren. Zwei der beiden Schrauben stellen die elektrische Verbindung zu den Leitungen für den oben beschriebenen Sapnnungswandler sicher.

Die anderen beiden Schrauben sind isoliert und sorgen für die mechanische Befestigung der Spulenüberwachungsvorrichtung über dem "Fischschwanz" oder den Eingangsleitern der Induktionsheizspule. Mit dem Gehäuse wird eine besonders zweckmäßige Anordnung für den Kabelabschluß und für die Anschlüsse für den Umformer und die Abtastwicklung erreicht. Alle elektrischen Verbindungen werden hergestellt, bevor alle Bauteile der Vorrichtung im Gehäuse vergossen werden. Das Kabel der Spulenüberwachungsvorrichtung ist in seiner Lage fest gehalten und alle Bauelemente sind arretiert, so daß die elektrischen Anschlüsse nicht mechanisch belastet sind, wenn die ganze Anordnung in üblicher Weise über den Eingangsleitungen der Induktionsheizspule angeordnet ist. Sowohl die Spannungs- als auch die Stromsignale stehen mit dem überwachten System über ein einziges Kabel mit vier Leitern in Verbindung. Das Kabel weist zwei abgeschirmte Leiterpaare auf, je eines für das Strom- und das Spannungssignal, und ist mit einer alle Leiter umgebenden, geklöppelten Kupferabschirmung versehen. Dieser Kabelbaum ist mit dem Eingang eines Mikroprozessors und dem Eingang einer Analog-Digital-Station verbunden, die dazu dienen, die verschiedenen Signale zu erzeugen, die für die erfindungsgemäße Spulenüberwachungsvorrichtung verwendet werden.

Weitere Merkmale und Vorteile der Erfindung ergeben sich aus der nachfolgenden Beschreibung und den Zeichnungen, worin eine bevorzugte Ausführungsform der Erfindung an einem Beispiel näher erläutert ist. Es zeigt:
- Fig.1: eine schematische Darstellung einer bekannten Anordnung, auf die sich die Erfindung bezieht;
- Fig.2: eine bevorzugte Ausführungsform der Erfindung in einer schematischen Darstellung;
- Fig.2A: einen erfindungsgemäß verwendeten Low-Pass-Filter in einem Verdrahtungsplan;
- Fig.3: eine erfindungsgemäße Spulenüberwachungsvorrichtung in einer schematischen Darstellung mit den Leitern für die von der Überwachungsvorrichtung ausgegebenen Spannungspegel;
- Fig.4: die Stromabtastwicklung der Erfindung in einer schematischen Darstellung;
- Fig.4A und 4B: Abwandlungen der Abtastwicklung für die bevorzugte Ausführungsform der Erfindung in einer Vorderansicht;
- Fig.5: eine schematische Darstellung einer weiteren Abwandlung der Abtastwicklung für die bevorzugte Ausführungsform der Erfindung;
- Fig.6 und 7: Betriebsmerkmale nach der Erfindung in Teil-Blockschaltbildern;
- Fig.8: zwei graphische Darstellungen eines Betriebsmerkmals nach der Erfindung;
- Fig.9 und 10: die Steuerschaltung zum Schalten bzw. Erzeugen verschiedener elektrischer Kennwerte, die mit der Erfindung bei verschiedenen Induktionsheizungsanordnungen verwendet werden, in Blockschaltbildern;
- Fig.11: die Abtastwicklung der Spulenüberwachungsvorrichtung nach der bevorzugten Ausführungsform der Erfindung, in einer Seitenansicht;
- Fig.12: das Trägergehäuse nach der bevorzugten Ausführungsform in einer auseinandergezogenen, perspektivischen Darstellung;
- Fig.13: das Spulenträgergehäuse in einer Vorderansicht;
- Fig.13A: den Gegenstand der Fig.13 in einem Schnitt längs der Linie 13A-13A;
- Fig.14: verschiedene, mit den in den Fig.9 und 10 gezeigten Schaltkreisen erzeugte Kennwerte in Abhängigkeit von der Zeit, in einer graphischen Darstellung;
- Fig.15: eine Anordnung, die die Erfindung zum Regeln der Eingangsleistung der Stromversorgungsvorrichtung während eines Heizzyklus verwendet, in einem Blockschaltbild;
- Fig.16: eine schematische Darstellung einer Induktionsheizungsanordnung zum Abtasten eines rotierenden Achszapfens unter Verwendung der erfindungsgemäßen Spulenüberwachungsvorrichtung;
- Fig.16A: eine schematische Darstellung des in Fig.16 dargestellten Verfahrens mit einem weiteren, bevorzugten Merkmal der Erfindung;
- Fig.17: die Erzeugung eines nach Fig.16A verwendeten Impedanzsignals durch die mit der Erfindung erzeugten, phasengleichen Spannungs- und Stromsignale, in einem Blockschaltbild;
- Fig.18: ein exzentrisches, innerhalb einer Induktionsheizspule rotierendes Werkstück, das von einer Anordnung überwacht wird, die von der bevorzugten Ausführungsform der Erfindung Gebrauch macht, im Schnitt;
- Fig.19: eine graphische Darstellung des Phasenwinkels, der Leistung und/oder der Impedanz, wie sie von einer erfindungsgemäß eingesetzten Einrichtung beim Überwachen des exzentrischen Werkstücks nach Fig.18 erzeugt werden;
- Fig.20: eine ausgegebene Kennungssignalanalyse einer Anordnung, die von der bevorzugten Ausführungsform der Erfindung Gebrauch macht, in einer graphischen Darstellung; und
- Fig.21 und 22: weitere Anwendungsfälle der bevorzugten Ausführungsform der Erfindung bei Kennsignalanalyseeinrichtungen, in schematischen Darstellungen.

Die Zeichnungen dienen lediglich zur Darstellung einer bevorzugten Ausführungsform der Erfindung, ohne diese jedoch darauf zu beschränken.

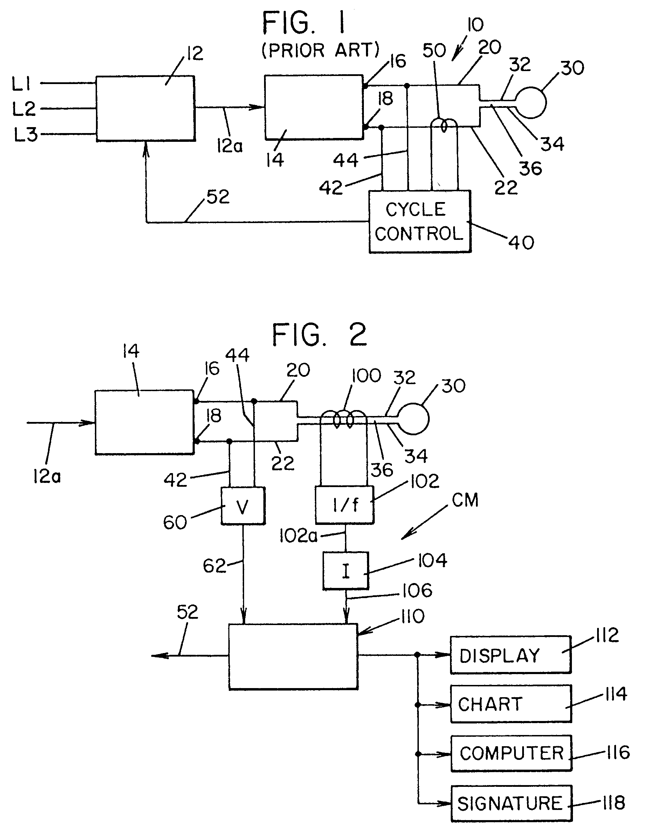

Fig.1 zeigt eine bekannte Energie-Überwachungseinrichtung 10 für eine Induktionsheizungsanordnung mit einer Drei-Phasen-Stromversorgung 12, deren Ausgang mit Hilfe eines (nicht gezeigten) phasengeregelten SCR-Netzwerkes (SCR network) eingestellt wird, um einer Arbeitsstation 14 einen Wechselstrom mit hoher Frequenz über einen ersten Leiter 12a zuzuleiten. Die Arbeitsstation 14 weist einen üblichen Wandler und einen Kondensator auf und hat Ausgangsklemmen 16, 18, an die Ausgangsleiter 20, 22 für eine Induktions-Heizspule 30 angeschlossen sind.

Die Induktionsheizspule 30 weist zwei mit geringem Abstand parallel verlaufende Leitungen oder Vielfachleitungen 32, 34 (buses) auf, die von einem Schlitz oder Spalt 36 voneinander getrennt sind, der normalerweise 0,5 bis 1,02 mm (0,02-0,04 in) breit ist. Die Leitungen oder Vielfachleitungen 32, 34 sind starke, im allgemeinen flache und zueinander parallele Kupferelemente, die mit der Spule 30 fest verbunden sind und die eine elektrische Strom- bzw. Spannungseinspeisung bilden, die häufig auch als "Fischschwanz" (fishtail) bezeichnet wird.

Die Energieüberwachungsanordnung weist eine Regelvorrichtung 40 auf, die häufig auch als Leistungskontrollgerät bezeichnet wird. Die ganze Einrichtung 10 überwacht die Energie, die einem Werkstück über die Spule 30 zugeführt wird. Hierzu regelt bzw. steuert die Vorrichtung 40 die dem Werkstück von der Spule zugeführte Energie und/oder die Dauer des Heiz-Arbeitstaktes. Hierbei wird die Spannung durch an die Ausgangsleiter 20, 22 angeschlossene Abtastleiter 42, 44 abgetastet. Bei dieser bekannten Einrichtung ist ein Stromwandler 50 oder -transformator um einen der Ausgangsleiter 20 bzw. 22 gewickelt, um eine Spannung zu erzeugen, die der Regelvorrichtung 40 zugeführt wird. Die Momentanleistung kann bestimmt werden, indem die Werte für den Momentanstrom und die Momentanspannung miteinander verknüpft werden. Dieser Leistungswert wird über die Zeit integriert, um die Energie zu bestimmen, die von der Induktionsheizspule 30 während eines Heizzyklusses aufgenommen wird. Über eine Steuerleitung 52 wird der Stromversorgung 12 ein Spannungssignal übermittelt, das den Phasenwinkel des SCR-Netzwerks in der Stromversorgung 12 steuert, um die der Spule 30 zugeführte Energie zu regeln. Das Signal in der Steuerleitung 52 kann auch dazu verwendet werden, den Heizzyklus nach der üblichen Technologie des Induktionserhitzens zu starten und zu beenden.

Mit der vorliegenden Erfindung ist es möglich, die Leistung direkt am Verbraucher oder der Spule 30 zu messen, wozu der Strom direkt am von den Leitungen 32, 34 gebildeten Fischschwanz gemessen wird. Auf diese Art und Weise werden Schwankungen in den Übertragungsleitungen, der Arbeitsstation 14 und Wandlern in der Stromversorgung 12 und der Arbeitsstation 14 vermieden. Die Spulenüberwachungsvorrichtung nach der Erfindung kann Werte messen oder erzeugen, die kennzeichnend sind für die Spulenenergie, die Spulenleistung, die Spannung, den Strom, die Impedanz, die Heizzeit und/oder die Frequenz. Darüber hinaus kann die Erfindung auch dazu verwendet werden, eine Exzentrizität bei der Rotation des Werkstücks sowie dessen Curie-Punkt-Temperatur (Austenitisierungstemperatur) und metallurgischen Zustand festzustellen. Der Strom wird im wesentlichen an der Spule selbst mittels einer einfach anzubringenden Anordnung gemessen, die auch als Trägergehäuse bezeichnet werden und bei den meisten Induktionsheizanlagen nachgerüstet werden kann.

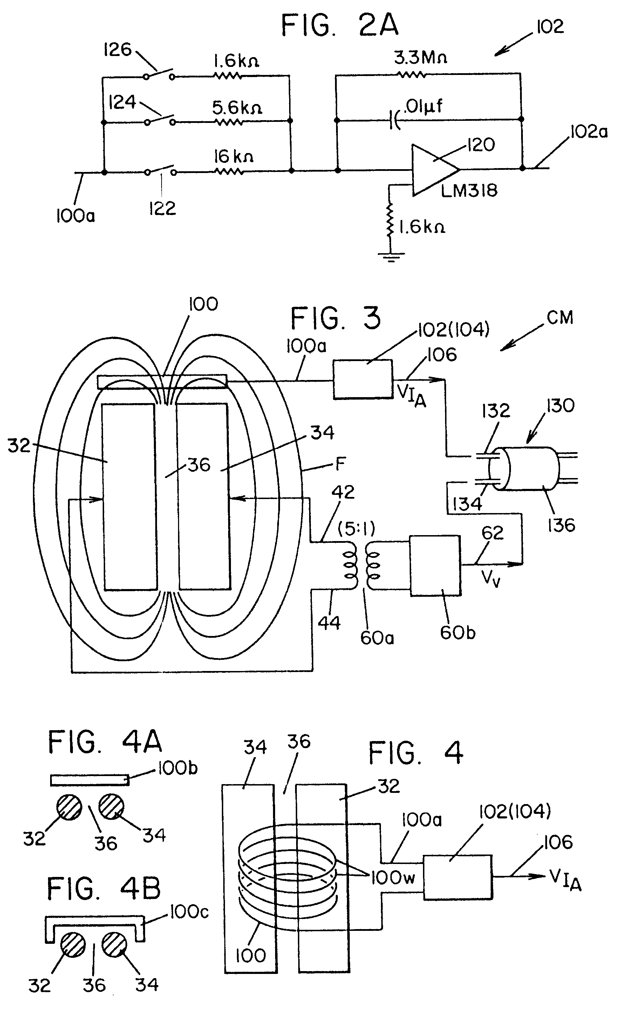

In Fig.2 sind Bauteile, die solchen nach Fig.1 entsprechen, mit denselben Bezugszeichen wie dort versehen. Fig.2 zeigt eine bevorzugte Ausführungsform der Erfindung mit einer Spulenüberwachungsvorrichtung CM, die ein in den Fig. 11-13A gezeigtes Spulenträgergehäuse und eine elektrische Einrichtung aufweist, um von im Gehäuse angeordneten Bauteilen gelieferte Daten gemäß der Aufgabe der Überwachungsvorrichtung zu verarbeiten. Im Gehäuse sind Abtastleiter 42, 44 zum Messen der zwischen den Ausgangsleitern 20, 22 anliegenden Spannung angeordnet. Die abgegriffene Spannung wird - wie zuvor beschrieben - einem Spannungswandler 60 Zugeführt, um in der Leitung 62 ein Spannungssignal zu erzeugen, dessen Größe ein Maß für die an der Spule anliegende Wechselstromspannung ist, die an den Ausgangsleitern 20, 22 gemessen wird. Um die Eingangsleitungen bzw. Vielfachleitungen 32, 34 ist eine neue, den Schlitz oder Spalt 36 übergreifende Abtastwicklung 100 mit mehreren Windungen gewickelt. Die Abtastwicklung 100 wird vom Spulenträgergehäuse gehalten und mißt den Fluß (Flux), der durch den Spalt 36 hindurchtritt. Dieser gemessene Wert stellt einen um 90° versetzten Spannungswert (voltage level shifted 90°) dar und ist von dem Spulenstrom und der Frequenz abhängig. Der gemessene Wert wird einem Filter 102 zugeleitet, der eine Verschiebung oder eine Umschaltung um 90° bewirkt. Der Filter 102 ist ein Low-Pass-Filter (etwa 500 Hz) und wird im Abfall- oder Grenzbereich (roll-off ranger) betrieben. Das vom Filter 102 über die Leitung 102a ausgegebene Ausgangssignal ist eine geradlinige, inverse Funktion der Stromfrequenz in der Spule 30. Da die Flux-Abtastwicklung 100 eine Spannung erzeugt, die eine geradlinige, direkte Funktion der Frequenz und um 90° versetzt ist, erzeugt der Filter in der Leitung 102a ein Spannungsniveau, das ein Maß für den Strom der Spule 30 ist. Der Wert in der Leitung 102a ist kein absoluter Wert, der direkt als Ampère ablesbar ist. Das Spannungsniveau in Leitung 102a ist jedoch ein Spannungssignal, das ein Maß für den Momentanstrom in der Spule 30 darstellt. Wenn sich der Spulenstrom verdoppelt, verdoppelt sich ebenfalls die Spannung in Leitung 102a. Da für die Steuerung bzw. Regelung des Spulenbetriebs beim induktiven Erwärmen oder beim Messen der Merkmale des von der Spule bestrichenen Werkstücks kein absoluter Stromwert erforderlich ist, ist es ausreichend, das den momentaren Strom anzeigende Spannungssignal vorzusehen, um die Spule 30 zu überwachen und um Ausgangssignale zu erhalten, die die Spuleneenergie, die Spulenleistung, die Spannung, Ampère (amphears), Impedanz, Heizzeit und/oder Frequenz anzeigen. Der Filter 102 kann im Spulenträgergehäuse oder auch außerhalb des Gehäusebereichs der Spulenüberwachungsvorrichtung angeordnet sein. Üblicherweise ist der Filter 102 ein externes Bauteil.

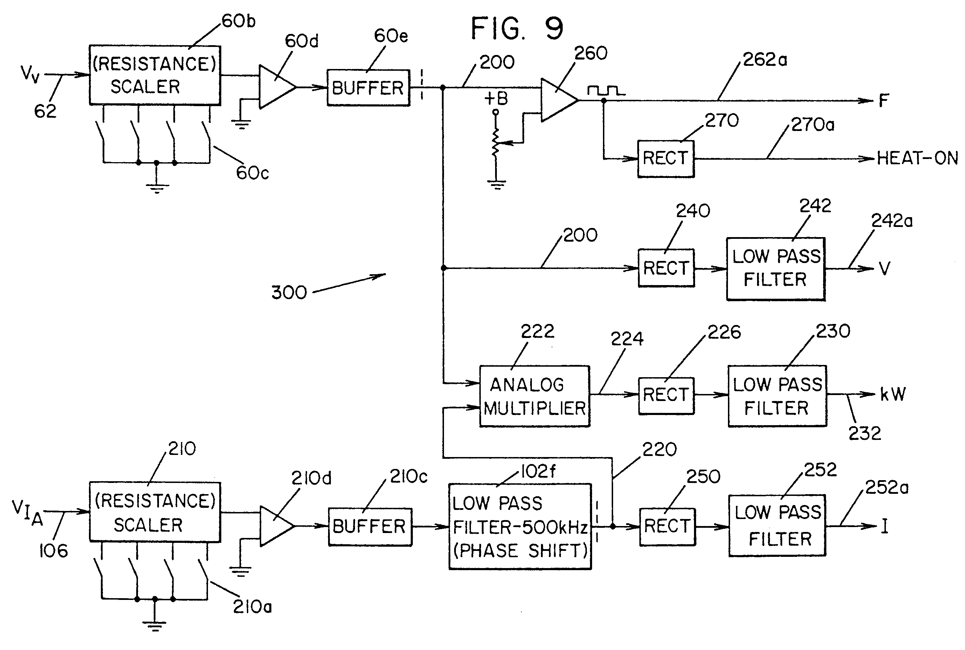

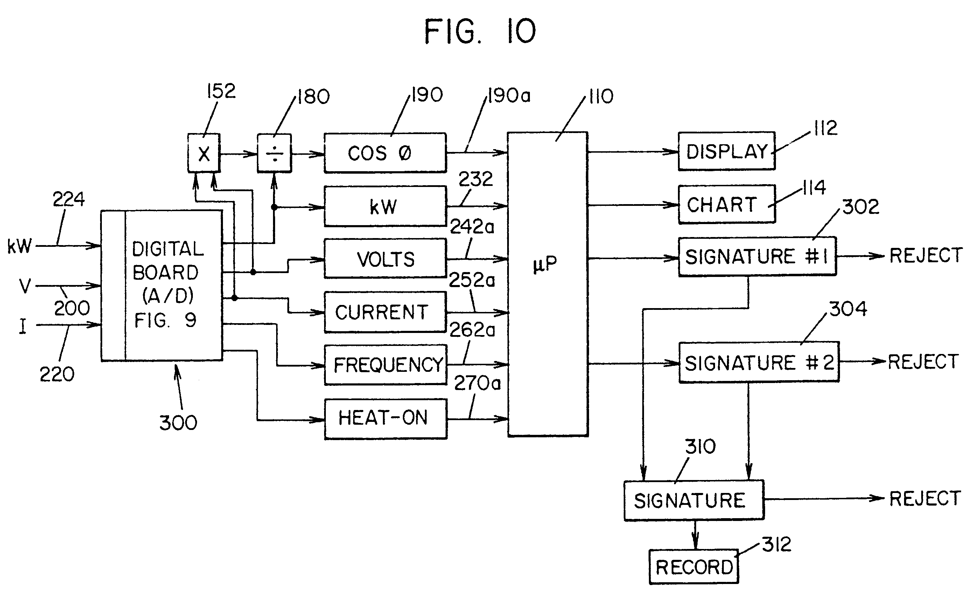

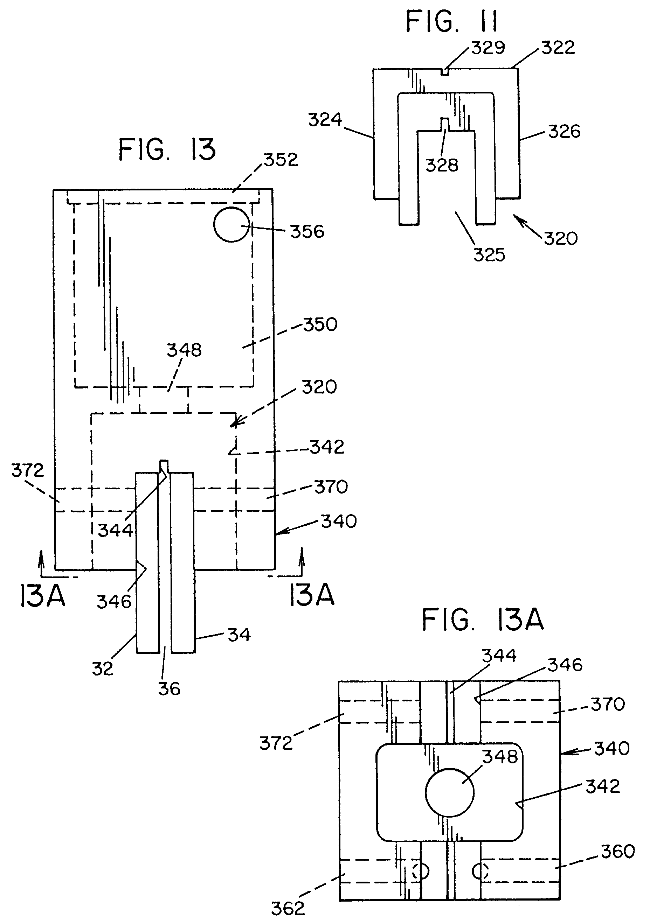

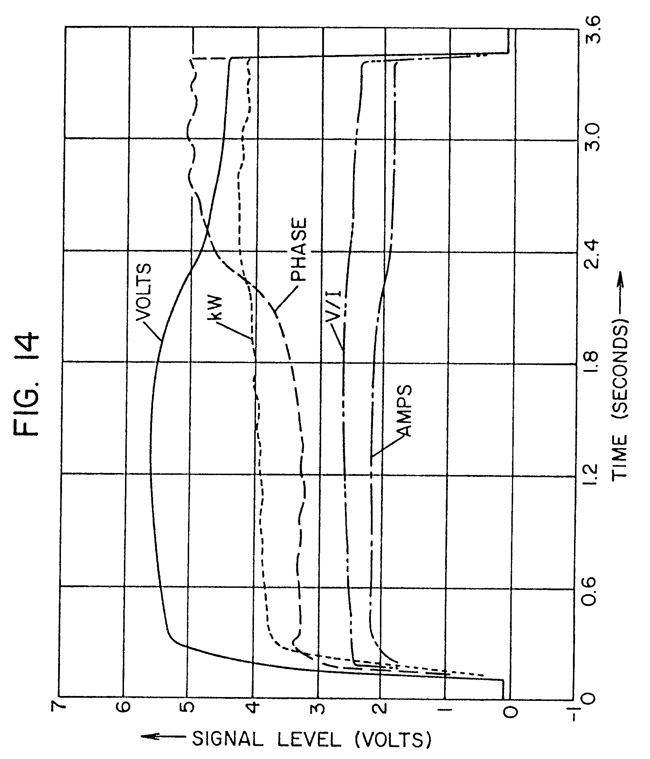

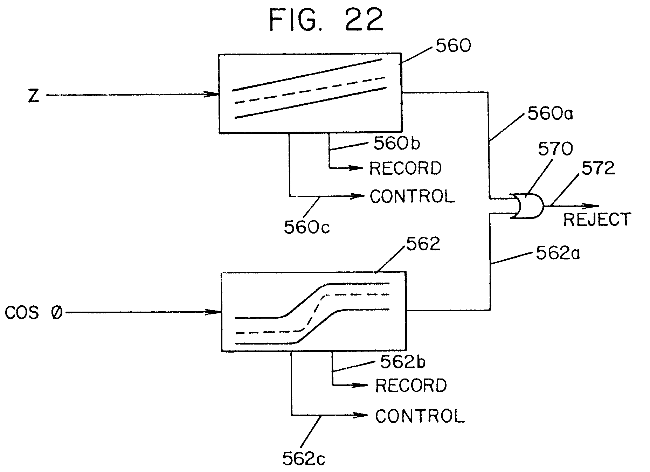

In dem elektrischen Schaltkreis ist ferner ein Skalierungsnetzwerk 104 (scaler network) oder eine Schaltvorrichtung im Abstand von dem Spulenträgergehäuse angeordnet. Diese Schaltvorrichtung 104 stellt die Höhe des in Leitung 102a anliegenden Spannungssignals auf ein gewünschtes Maß ein und gibt über die Leitung 106 ein Signal ab, das von einem Mikroprozessor 110 mit Eingangsnetzwerk verarbeitet wird, wie dies am besten in Fig.9 dargestellt ist. Der Mikroprozessor empfängt das den Momentanwert der Wechselstromspannung darstellende Spannungssignal über die Leitung 62 und über die Leitung 106 eine Spannung, die ein Maß für die Größe des momentanen Wechselstroms ist. Diese Spannungssignale werden wie in Fig.9 dargestellt verarbeitet und nach Fig.10 an verschiedene, geeignete Ausgabegeräte ausgegeben. Wie sich aus Fig.2 ergibt, können die von der Spulenüberwachungsvorrichtung CM bestimmten Meßgrößen a) als direkt ablesbare, durch Block 112 dargestellte Informationswerte angezeigt werden und/oder b) sie können in Form einer durch Block 114 angedeuteten Tabelle wie in Fig.14 dargestellt werden und/oder c) sie können als Informationswerte einem durch Block 116 angedeuteten Computer für verschiedene Prozeßsteuerungen bzw. -regelungen eingegeben werden, wie sie in dieser Anmeldung beschrieben sind und/oder sie können in Kennungssignal-Analyseeinrichtungen verwendet werden, wie sie durch den Block 118 angedeutet und in den Fig. 20-22 gezeigt sind.

In Fig.2A ist der Low-Pass-Filter 102 dargestellt. Der Filter 102 weist einen Rechenverstärker 120 auf, der die niedrige Frequenz durchläßt und dessen Abfall-Frequenzniveau von Schaltern 122, 124 und 126 gesteuert wird. Wenn die Spulenüberwachungsvorrichtung CM dazu verwendet wird, einen 1,0 Khz Induktions-Heizbetrieb zu überwachen, wird der erste Schalter 122 geschlossen. Zum Überwachen eines 3,0 Khz Betriebes wird der zweite Schalter 124 geschlossen. Der dritte Schalter 126 wird geschlossen, wenn im 10 Khz Induktions-Heizbetrieb gearbeitet wird. Dieser Low-Pass-Filter versetzt den Phasenwinkel der von der Abtastwicklung 100 kommende Wechselstromspannung in der Leitung 100a um 90° in der Ausgangsleitung 102a. Darüberhinaus nimmt das Spannungsniveau in der Ausgangsleitung 102a in geradliniger Funktion ab, wenn die Frequenz in der Leitung 100a ansteigt. Die umgekehrte Frequenzantwortfunktion tritt in Leitung 100a von der Abtastwicklung 100 auf. Die Ausgangsspannung der Abtastwicklung 100 ist eine geradlinige Funktion, die mit der Frequenz ansteigt. Der Betrieb des Filters 102 ist eine Umkehrfunktion der Frequenz im Bereich der in der Spule 30 verwendeten Frequenz. Demgemäß ist der Ausgang in der Leitung 102a ein Spannungswert, der sich nach dem momentaren Strom der Induktions-Heizspule 30 ändert, denn der Einfluß der Frequenz auf die induzierte Spannung wird mit dem Filter 102 aufgehoben.

Fig.3 zeigt die gesamte, am Fischschwanzbereich der Vielfachleitungen 32, 34 angeordnete Spulenüberwachungsvorrichtung CM. Die in den Leitungen 42, 44 anliegende Spannung wird im Wandler 60a umgeformt, der ein Umsetzungsverhältnis von 5:1 hat. Die transformierte Spannung wird einer Skaliereinrichtung 60b zugeführt, wie sich am besten aus Fig.9 ergibt. Hierdurch wird in der Leitung 62 ein Spannungssignal erzeugt. In ähnlicher Weise tritt ein den Strom repräsentierendes Spannungssignal in der Leitung 106 auf. Diese Signale werden von dem Spulenträgergehäuse oder -aufbau für die an den Leitungen 32, 34 angeordnete Abtastwicklung 100 durch ein flexibles Kabelgeschirr 130 mit einzelnen abgeschirmten Leitungen 132, 134 für die Leiter 106 bzw. 62 geführt. Um die Leitungen 132, 134 herum ist Gesamtabschirmung 136 aus Kupfer angeordnet, um jede etwaige elektromagnetische Interferenz mit den Signalen zu vermeiden, die von dem Gehäusebereich der Spulenüberwachungsvorrichtung CM zu einem in Fig.9 und 10 gezeigten, entfernt angeordneten Analog-Digital-Bord übermittelt werden. In Fig.4 ist eine schematische Darstellung der tatsächlichen Ausgestaltung der Wicklung 100 gezeigt, worin Umwindungen 100w entlang des oberen Bereichs des zwischen den Leitungen 32, 34 befindlichen Spalts 36 gewickelt sind. Bei dieser Anordnung kreuzt der nach oben oder nach unten gerichtete Fluß durch den Spalt 36 die Windungen 100w der Abtastwicklung 100, wodurch ein Signal in dem Leiter 100a erzeugt wird. Die Anzahl der Windungen 100w kann so eingestellt werden, daß sie einen größeren Bereich des Spaltes 36 überdecken. Diese Anzahl ist jedoch kein wesentliches Merkmal der vorliegenden Erfindung. In Fig.4A ist die Wicklung 100b lediglich oberhalb des Spaltes 36 angeordnet. In Fig.4B ist die Wicklung 100c sattelartig bis über die Seiten der Leitungen 32, 34 gezogen. Die Wicklungen 100b, 100c haben die Aufgabe, den gesamten durch den Spalt 36 in dem von der Abtastwicklung 100 überwachten Bereich durchtretenden Fluß F zu erfassen, wie dies in den Fig.3 und 4 dargestellt ist.

Soweit bislang beschrieben, betrifft die Erfindung eine den Spalt 36 überdeckende Wicklung, die ein Spannungssignal erzeugt, dessen Größe ein Maß für den durch die Spule 30 fließenden Strom darstellt. Dies ist eine einzigartige, neue und besonders vorteilhafte Anordnung zum Bestimmen des momentanen Stromflusses in der Spule 30, wobei die Messung des Stromflusses in der Spule nicht von elektrischen Schwankungen von der Stromversorgung zur Spule 30 beeinflußt wird. Dies ist ein primäres Merkmal der Erfindung und führt zu den bislang beschriebenen Vorteilen.

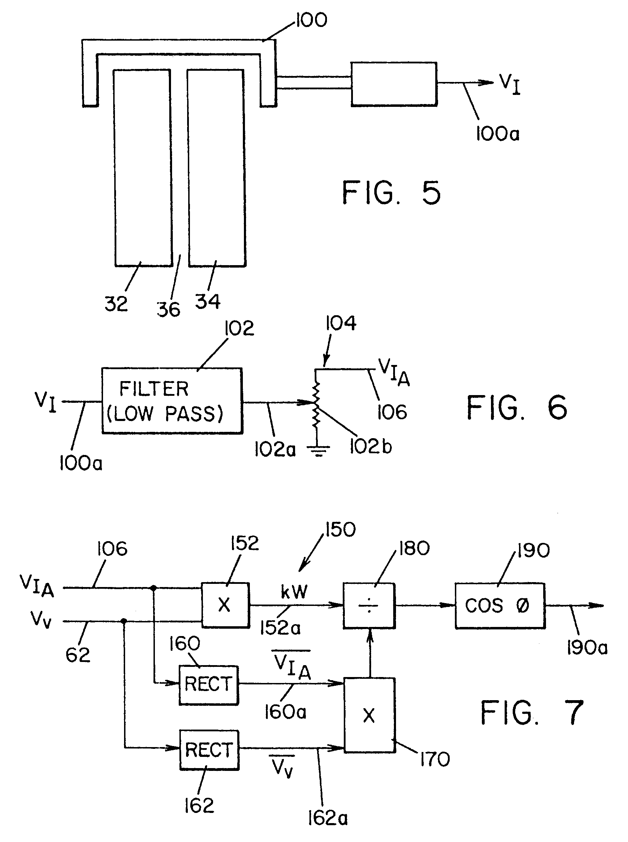

Fig.5 und 6 zeigen gemeinsam die grundlegenden Merkmale der bevorzugten Ausführungsform der Erfindung. Die Spule 100 erstreckt sich in Längsrichtung mit mehreren Windungen über das Kopfende des Spaltes 36. In der bevorzugten Ausführungsform ist die Wicklung 100 sattelförmig ausgebildet, wie dies in Fig.5 gezeigt ist. Das Ausgangsspannungssignal im Leiter 100a wird dem Filter 102 zugeführt, der eine Ausgangsleitung 102a hat, wie dies in Fig.6 dargestellt ist. Die erste Skaliereinrichtung 104 zum Einstellen des Stromsignals ist ein Spannungsteiler 102b, der dazu dient, eine vorgegebene Spannung in einer Leitung 106 zu erzeugen. Die in den Fig.5 und 6 gezeigten Bauteile sind entfernt von dem Tragkonstruktionsteil bzw. dem Gehäuse der Spulenüberwachungsvorrichtung CM angeordnet. Die an der Leitung 106 anliegende Spannung wird einem Analog-Digital-Wandler und einem Mikroprozessor zugeleitet, wie dies zuvor bereits beschrieben wurde. Diese zwei Signale in den Leitungen 62 und 106 werden miteinander verknüpft, um einen Cosinus des Phasenwinkels zwischen dem Strom und der Spannung der Spule 30 zu erzeugen.

Fig.7 zeigt ein schematisch dargestelltes Cosinus-Unterprogramm in Form eines Blockdiagramms. Die Cosinusfunktion des Phasenwinkels ist ein eindeutiger und klarer Kennwert, der sich bei bestimmten metallurgischen und strukturellen Veränderungen sowie bei Temperaturänderungen des in der Spule 30 befindlichen Werkstücks drastisch verändert. Dies erzeugt einen unmittelbaren Meßwert für die Momentanleistung der Spule C, der in der Leitung 152a anliegt.

Das Spannungssignal in der Leitung 106 wird von dem Gleichrichter 160 entzerrt bzw. gleichgerichtet, um einen Gleichstromwert zu erzeugen, der als Maß für den Spulenstrom in einer Leitung 160a anliegt. In ähnlicher Weise erzeugt ein zweiter Gleichrichter 162 einen Gleichstromwert, der die Spulenspannung anzeigt und der in einer Leitung 162a anliegt. Die Gleichstromwerte werden im Schaltblock 170 miteinander multipliziert und bilden den Teiler für einen Teilerblock 180. Dieser Teilerblock 180 erzeugt den Quotienten aus der Momentanleistung, geteilt durch das Produkt von Gleichstrom-Stromstärke und Gleichstrom-Spannung. Auf diese Weise wird der Cosinus des Phasenwinkels erzeugt, was durch den Schaltblock 190 mit dem Ausgang 190a dargestellt ist. Die gleichen Bauteile sind in dem Ausgangsnetzwerk nach Fig.10 dargestellt.

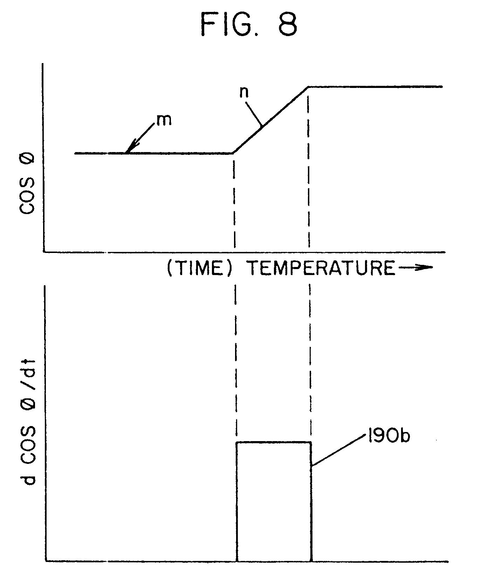

Fig.8 zeigt eine graphische Darstellung, worin der Cosinus des Phasenwinkels über der Zeit aufgetragen ist. Dies ist ein Graph m, der in einem Bereich n von einem niedrigeren auf ein höheres Niveau übergeht. Nach dieser Darstellung verändert sich der Phasenwinkel, wenn das Werkstück die Umwandlungstemperatur oder die Temperatur des Curie'schen Punktes über- bzw. unterschreitet. Durch Differenzieren der im oberen Teil der Fig.8 gezeigten Kurve m wird ein Impuls 190b erzeugt. Die vordere Kante dieses Impulses zeigt den Zeitpunkt an, in dem das Werkstück durch die Curie-Punkt-Temperatur hindurchgeht. Der Cosinus des Phasenwinkels verändert sich in Übereinstimmung mit anderen Kennwerten stark und wird als leicht meßbarer Parameter dazu verwendet, verschiedene Charakteristika und Änderungen abzutasten, die von der Spule 30 festgestellt werden, während sich diese entlang eines zu erhitzenden Werkstücks bewegt oder entlang eines Werkstücks verfährt, das in Übereinstimmung mit standardmäßiger Wirbelstromtechnik vermessen wird.

Die Erfindung wurde soweit in Bezug auf die Erzeugung des Spannungssignals in Leitung 62 und des Stromsignals in Leitung 106 erläutert. Diese beiden Werte können in einer Vielzahl von analogen und digitalen Systemen dazu verwendet werden, verschiedene ablesbare Kenngrößen zu erzeugen, die kennzeichnend für die Funktion der Spule 30 sind. Mit der Erfindung wird der Strom mittels einer Abtastvorrichtung abgetastet und als Spannungsgröße gemessen, die unmittelbar in der Nähe der Spule 30 angeordnet ist. Diese Anordnung ist beim induktiven Erwärmen und Härten bislang nicht angewendet worden. Die spezielle Schaltung, die Mikroprozessoren, Computer und anderen Hardware-Komponenten zur Erzeugung und Anwendung der verschiedenen Kenngrößen können verschiedene, bekannte und herkömmliche Ausgestaltungen haben. Bei der bevorzugten Ausführungsform wird die Spulenüberwachungsvorrichtung dazu verwendet, eine Anzahl von Kenngrößen zu erzeugen und eine Anzahl von Aufgaben zu erfüllen, wie dies schematisch in den Fig.9 und 10 gezeigt ist.

Nach Fig.9 weist die Skaliereinrichtung 60b ein Schalternetzwerk 60c auf, um die Größe des Spannungssignals auf Leitung 62 maßstäblich zu verändern. Dieses Signal wird dann mit dem Verstärker 60d verstärkt und durch ein Dämpfungsglied (buffer) 60e geleitet. Dieser Schaltkreis erzeugt ein Spannungssignal in einer Leitung 200, das ein Wechselstromsignal ist und das ein Maß für die Spannung an der Spule 30 darstellt. In ähnlicher Weise hat die Schaltvorrichtung 210 ein Schalternetzwerk 210a, das am Eingang des Verstärkers 210d ein Signal erzeugt. Das so verstärkte Signal wird dann durch ein Dämpfungsglied 210c geleitet. Bei der bevorzugten Ausführungsform der Erfindung ist der Filter 102 tatsächlich im Abstand von der Trägeranordnung bzw. dem Gehäuse angeordnet, auch wenn er bei einigen Ausführungsformen an der Trägeranordnung selbst angebracht sein kann.

In Fig.9 ist ein entfernt angeordneter Filter schematisch als Low-Pass-Filter 102f dargestellt. Dieser Low-Pass-Filter hat einen Abfall (roll-off) von 500 Khz und verschiebt das von dem Puffer 210c kommende Signal um 90°. Der entfernt angeordnete Filter 102f entspricht dem Filter 102, der in Verbindung mit Fig.2 beschrieben wurde. Die Zeichnung zeigt eine andere Anordnung für den Filter, der in der bevorzugten Ausführungsform der Erfindung außerhalb der Trägeranordnung für die über den Leitungen 32, 34 angeordnete Spulenüberwachungsvorrichtung angebracht ist. Die Spulenüberwachungsvorrichtung besteht also im wesentlichen aus der an den Leitern 32, 34 angeordneten Trägeranordnung und dem entfernt angeordneten Schaltkreis zum Erzeugen von Kennwerten aufgrund der Ausgangssignale vom Trägergehäuse bzw. der Trägeranordnung, die unmittelbar an der Spule angebracht ist. Die eingehenden Signale werden mit Hilfe der Schaltvorrichtungen 60b und 210 auf angemessene Schaltwerte maßstäblich vergrößert bzw. verkleinert. Die Leitungen 62, 106 sind an den in Fig.9 gezeigten Schaltkreisen im Differentialmodus (differential mold) angeschlossen. Der Eingang zum Rechenverstärker 60d wird im Differentialmodus gehalten, um Spannungen im gewöhnlichen Modus (common mode voltages) abzuweisen. Der Ausgang des Verstärkers 60d wird von dem Dämpfungsglied 60e für die Verwendung in dem analogen Schaltkreis nach Fig.9 gepuffert. Nachdem das Stromsignal den Filter 210c passiert hat, ist die Größe der in Leitung 220 anliegenden Spannung ein Maß für den durch die Spule 30 fließenden Wechselstrom. Das Ausgangssignal auf Leitung 220 wird zusammen mit dem gepufferten Spannungssignal auf Leitung 200 einer analogen Multipliziereinrichtung 222 zugeleitet. Das Ausgangssignal 224 von der Multipliziereinrichtung 222 wird von einem ersten Gleichrichter 226 gleichgerichtet und durch einen ersten Low-Pass-Filter 230 geführt, um an der Ausgangsleitung 232 eine Spannung zu erzeugen, die ein Maß für das Leistungs- oder Kilowattniveau kW in der Spule 30 ist. Außerdem wird das in Leitung 200 anliegende Signal von einem zweiten Gleichrichter 240 gleichgerichtet und durch einen zweiten Low-Pass-Filter 242 geleitet, um das Gleichstromspannungssignal an der Ausgangsleitung 242a zu erzeugen. Das an Leitung 220 anliegende Stromsignal wird von einem dritten Gleichrichter 250 gleichgerichtet und durch einen dritten Low-Pass-Filter 252 geleitet, um einen Gleichstromwert an der Ausgangsleitung 252a zu erzeugen. Im oberen Teil von Fig.9 ist ein Vergleicher 260 dargestellt, der von der Wechselstromspannung auf Leitung 200 beaufschlagt ist. Dadurch wird ein Rechteckwellen-Ausgangssignal auf Leitung 262a erzeugt, das die Frequenz an der Spule 30 darstellt. Der Mikroprozessor 110 zählt die einzelnen Impulse auf der Leitung 262a in einem bestimmten, bekannten Zeitintervall, um die Frequenz abzulesen. Ein vierter Gleichrichter 270 erzeugt ein "Heizung-An"-Signal in Leitung 270a. Dieses Signal hat einen logischen Wert "1", wenn ein Heizzyklus von der Spule 30 durchgeführt wird. Alle diese Ausgangssignale 232, 242a, 252a, 262a und 272a sind Gleichstrom-Kennwerte, die von den Wechselspannungen in den vom Trägergehäuse der Spulenüberwachungsvorrichtung kommenden Leitungen 62, 106 gesteuert werden, das in der Nähe der Spule 30 angeordnet ist. Die rechte Seite von Fig.9 stellt eine Digitaltafel (digital board) 300 dar, die an der Eingangsseite von Fig.10 schematisch dargestellt ist.

An der Ausgangsseite von Fig.10 befindet sich u.a. eine Anzeigevorrichtung 112 und Hardwarekomponenten 114 zum Erzeugen von Tabellen und/oder Übersichtsdiagrammen. Die verschiedenen, vom Mikroprozessor 110 gelieferten Kennwerte können auch für die Kennungssignal-Analyse verwendet werden, wie dies durch die Schaltblöcke 302, 304 angedeutet ist. Wenn die Kennwerte beim Heizen nicht mit vorgegebenen Kennungssignalen übereinstimmen, werden die Werkstücke ausgemustert, was durch die Ausgangspfeile an den Schaltblöcken 302, 304 angedeutet ist. Eine weitere Kennungssignal-Analysevorrichtung 310 stellt eine Kombination von Kennungssignalanalysesystemen dar, die zwei verschiedene Kennungssignale verwendet, wodurch ein Werkstück ausgemustert wird, wenn einer der Kennwerte ein vorgegebenes Profil über- oder unterschreitet. Gemäß der dargestellten Ausführungsform werden die von dem Mikroprozessor 110 oder einem Computer erzeugten Kennungssignale von einem passenden Hardwarebauteil 312 aufgezeichnet. Die Kennungssignalanalyse, die von der Erfindung Gebrauch macht, ist in weiteren Einzelheiten in den Fig.20-22 dargestellt.

Ein Hauptvorteil der Erfindung ist die Möglichkeit, den Spulenstrom durch eine vergleichsweise einfache, mechanische Anordnung oder eine Trägeranordnung zu messen, die einfach über den Fischschwanz an der Spule 30 geschoben werden kann, wobei die Abtastwicklung 100 unmittelbar oberhalb des Spaltes 36 angeordnet ist. Die Trägeranordnung oder das -gehäuse hierfür ist in den Fig.11-13A dargestellt.

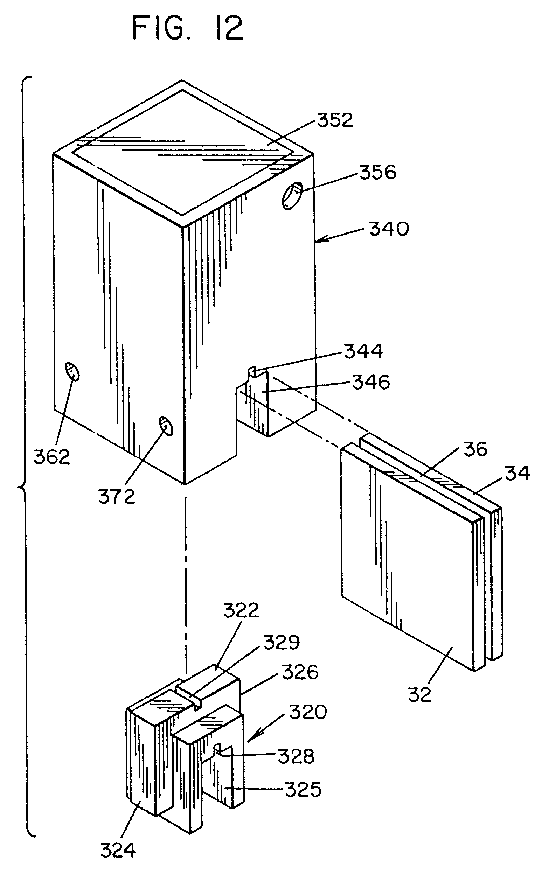

Fig.11 zeigt einen Wicklungshalter 320 mit einem sattelförmig ausgestalteten Abstandhalter 322, der mit sich nach unten erstreckenden Seitenteilen 324, 326 oder Schenkeln versehen ist. Der Abstandhalter ist mit einem Schlitz 328 versehen, der die zwischen den Leitungen 32, 34 in dem Spalt 36 verlaufende Isolierung bzw. den Isolierungsschlauch aufnimmt. Die Abtastwicklung 100 ist um den Halter 320 gewickelt, der dann über den Leitungen 32, 34 angeordnet ist, wie dies am besten aus Fig.12 ersichtlich ist. Der Halter 320 wird in einer unteren Ausnehmung 342 eines Trägergehäuses 340 aufgenommen, die mit einem passenden Einschnitt 344 in der Mitte eines Schlitzes 346 versehen ist, der die Leitungen 32, 34 aufnimmt. Ein oben am Wicklungshalters 320 befindlicher, oberer Schlitz 329 dient zum Festlegen der Abtastwicklung, nachdem diese um den Abstandhalter 322 gewickelt wurde. Die Wicklungsenden der Abtastwicklung 100 werden nach oben durch eine Öffnung 348 im Trägergehäuse geführt, nachdem der Wicklungshalter 320 mit der Abtastwicklung 100 umwickelt und in der Ausnehmung 342 angeordnet ist. In der Praxis ist der Wicklungshalter 320 etwa 25,4mm (1,0 in) lang und sein zentraler Aufnahmeschlitz 325 etwa 15mm (0,59in) breit. Die Abmessungen der Ausnehmung 342 haben eine Länge von etwa 25,7mm (1,01 in) und eine Breite von etwa 38,4mm (1,51 in). Diese Abmessungen sind an die Außenabmessungen des Wicklungshalters 320 angepaßt. Das Gehäuse 340 weist eine obere Schaltkreis-Aufnahmekammer 350 auf, in dem die Schaltkreise als Teil des Gehäuses 340 aufgenommen und eingegossen sind. Die Aufnahmekammer 350 ist mit einer oberen Abdeckung 352 versehen. Seitlich im Gehäuse ist eine Öffnung 356 angeordnet, durch die ein Kabelbaum 130 austritt und zu dem entfernt angeordneten Schaltkreis am Mikroprozessor führt. Im Gehäuse sind weiter Öffnungen 360,362 für isolierte Stellschrauben angeordnet, die zum Befestigen des Gehäuses 340 an den Leitungen 32, 34 dienen. Weiterhin sind im Gehäuse Klemmschrauben 370, 372 mit Kontaktstellen vorgesehen, die in Kontakt mit den einander gegenüberliegenden Leitungen 32, 34 sind, um die an der Spule 30 anliegende Spannung in direkter Messung abzugreifen. Das Gehäuse oder der Träger kann verschieden ausgebildet sein, um die Abtastwicklung lösbar über dem Spalt oder Schlitz 36 an der Spule 30 anzuordnen. Die Fig. 11-13A dienen lediglich zur Darstellung des prinzipiellen Aufbaus, wie er weiter bei der bevorzugten Ausführungsform verwendet wird.

Fig.14 zeigt verschiedene, graphisch dargestellte Kennwerte in Abhängigkeit von der Zeit, wie sie von der Spulenüberwachungsvorrichtung beim Erwärmen eines Werkstücks erzeugt werden. Bei dieser speziellen Darstellung ist erkennbar, daß sich der Phasenwinkel beim Erreichen des Curie'schen Punkts des Werkstücks beim Aufheizen sehr stark ändert. Die Dauer eines Arbeitstaktes beträgt etwa 3,5 Sekunden. Nach etwa 1,8s erreicht das Werkstück die Temperatur am Curie'schen Punkt oder die Umwandlungstemperatur. Die Spannung wie auch die übrigen Parameter ändern sich hier nur wenig; der Phasenwinkel oder der Cosinus des Phasenwinkels verändert sich jedoch schnell bzw. stark. Ein Hauptmerkmal der bevorzugten Ausführungsform der Erfindung ist es daher, die Spulenüberwachungsvorrichtung zum Erzeugen eines Signals zu verwenden, das den Cosinus des Phasenwinkels zwischen dem Momentanstrom und der Momentanspannung an der Spule anzeigt. Dieser wichtige Aspekt der Erfindung ist in den Schaltbildern nach Fig.7 und Fig.10 dargestellt.

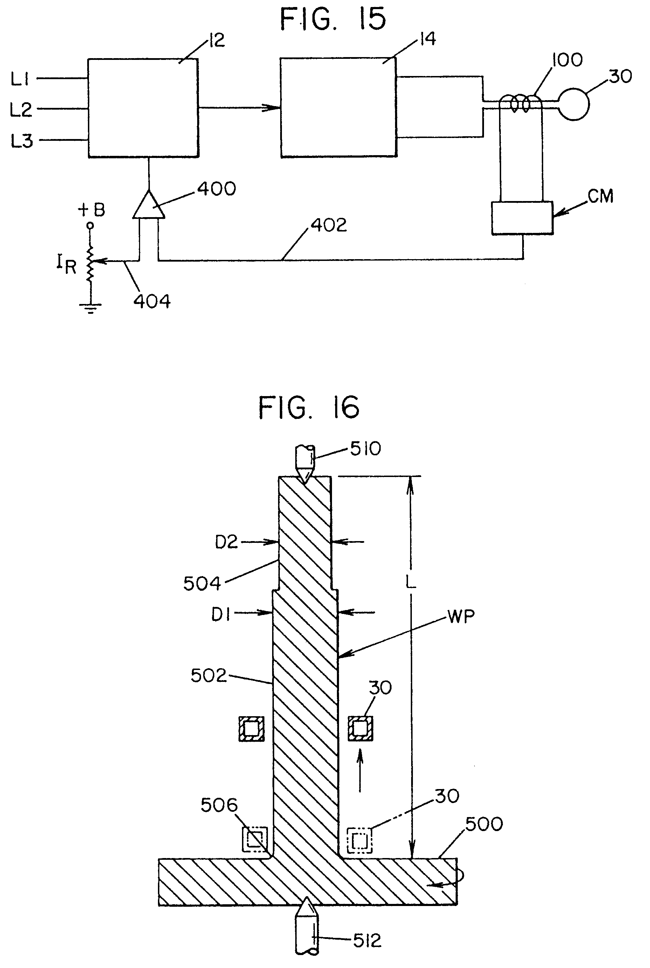

Fig.15 zeigt einen Anwendungsfall der Erfindung, worin die Spulenüberwachungsvorrichtung ein Signal auf der Leitung 402 erzeugt, das die von der Spule 30 verbrauchte Leistung anzeigt. Ein Komparator 400 vergleicht die Momentanleistung aus Leitung 402 mit einem an der Leitung 404 anliegenden Referenz-Leistungswert, um den Phasenwinkel des SCR-Netzwerks in der Stromversorgungseinrichtung 12 zu regeln. Dies stellt eine interaktive Regelungsanordnung dar, die von einer Spulenüberwachungsvorrichtung nach der bevorzugten Ausführungsform der Erfindung Gebrauch macht.

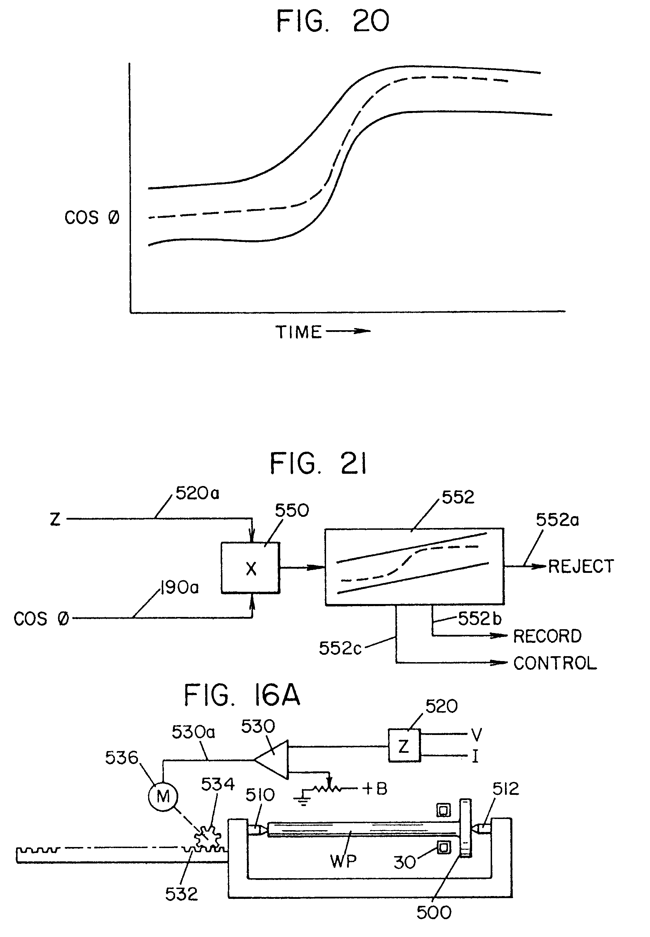

Eine andere Anwendungsmöglichkeit der Erfindung ist in Fig.16 dargestellt, worin ein Werkstück WP in Form einer Steckachse mit einem Flanschteil 500 und einem Achsenteil 502 mit verjüngtem bzw. abgesetztem Achsende 504 zwischen Zentrierspitzen 510, 512 gedreht wird. Das Werkstück WP wird von einem Induktor oder einer Spule 30 abgetastet, wie dies beim induktiven Erwärmen üblich ist. Mit der Erfindung kann die Auskehlung 506 am Übergang vom Flanschteil zum Achsenteil als Start- bzw. Endpunkt für die Abtastung bestimmt werden. Wenn das Werkstück oder der Konduktor 30 nach oben bzw. nach unten bewegt wird, wird die Impedanz der Spule 30 gemessen. Diese Messung wird durchgeführt, indem die Spule 30 mit einen Wechselstrom mit vergleichsweise geringer Stromstärke beaufschlagt wird. Wenn sich die Impedanz während der Relativbewegung um einen bestimmten Betrag erhöht, zeigt dies an, das die Auskehlung 506 am Flanschteil 500 erreicht ist und die Relativbewegung zwischen Spule und Werkstück wird beendet. Diese Impedanzmessung mit Hilfe des erfindungsgemäßen Schaltkreises nach Fig.7 erlaubt es, den Heizbetrieb genau zu starten, ohne daß es hierzu einer mechanischen Einrichtung oder dem Eingriff einer Bedienungsperson bedarf. Beim Abtasten wird die Spule oder der Induktor 30 mit voller Leistung beaufschlagt, bis der Absatz zwischen dem Achsteil 502 und dem Achsende 504 durch eine Veränderung eines Kennwertes abgetastet wird. Die der Spule zugeführte Leistung wird dann verringert, um das Achsende 504 zu erhitzen. Bei Erreichen des Werkstückendes verändern sich die überwachten Kennwerte sehr stark. Der Heizvorgang wird daher beendet, wenn die Spule das Werkstückende erreicht. Diese Verfahrensweise weist gegenüber bisher bekannten Verfahren Vorteile auf, bei denen die zu härtende Werkstücklänge und damit der Relativweg zwischen Spule und Werkstück festgelegt ist, die Werkstücklänge sich jedoch bei ansteigender Werkstücktemperatur in häufig nicht zu vernachlässigender Weise verändert. Die Erfindung erleichtert es festzustellen, wann die Spule die Auskehlung 506 und das Ende des Werkstücks WP beim Abtasten der in Fig.16 als Beispiel gezeigten Steckachse erreicht und kann auch infolge von Wärmedehnungen veränderte Werkstückabmessungen einfach berücksichtigen.

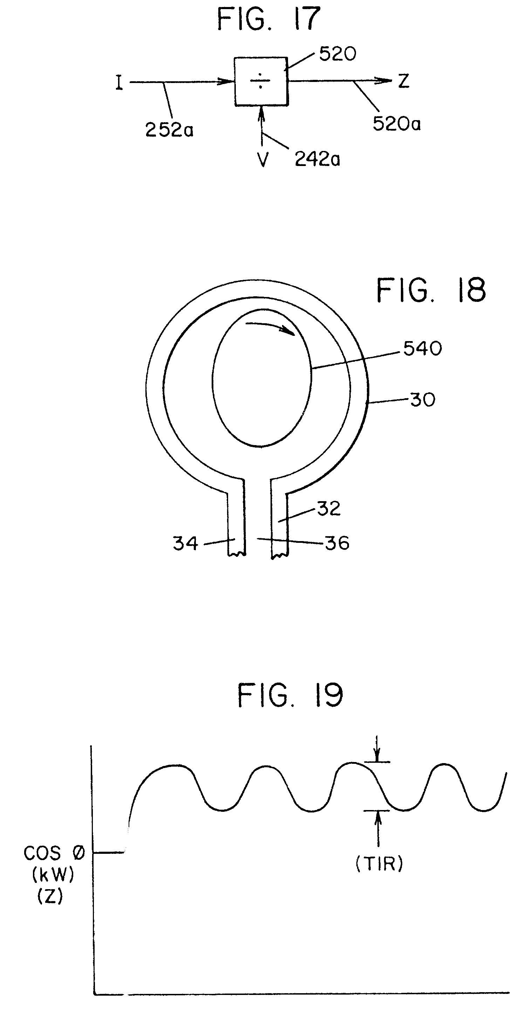

Fig.17 zeigt eine schematische Darstellung eines Hartdraht-Schaltkreises (hardwired circuit), mit dessen Hilfe die in den Leitungen 242a und 252a anliegenden Gleichstromwerte miteinander verknüpft werden, um einen Impedanz- oder Widerstandswert zu erzeugen, wie er bei der Anordnung nach Fig.16 verwendet wird. Dieser Impedanzwert wird von dem Mikroprozessor erzeugt und kann graphisch wie Fig.14 durch die Kurve V/I dargestellt werden. Der Schaltblock 520 stellt die Erzeugung des Impedanzwertes Z dar, der durch Verknüpfung der Kennwerte durch den Mikroprozessor, einen Computer oder den dargestellten Hartdraht-Schaltkreis erzeugt wird. Mit der Erfindung ist es möglich, den Impedanzwert Z sehr genau zu bestimmen, da der zugrundeliegende Stromwert unmittelbar auf dem Strom basiert, der an der Spule oder dem Induktor 30 anliegt. Der im Schaltblock 520 erzeugte Impedanzwert Z kann bei einer Anordnung verwendet werden, wie sie in Fig.16A gezeigt ist, die Fig. 16 und 17 miteinander kombiniert.

Nach Fig. 16A wird der Impedanzwert Z einem Komparator 530 zugeführt, dessen Ausgangssignal 530a einen Servomotor 536 für einen Zahnstangenantrieb 532, 534 steuert. Mit dieser Anordnung wird das Werkstück WP gegenüber der Spule 30 relativ bewegt, um die Achse des Werkstücks abzutasten. Der Motor 536 wird in Abhängigkeit von Unterschieden der gemessenen Impedanz Z gegenüber einer vorgegebenen Impedanz betrieben. Fig.16A stellt einen Anwendungsfall der Erfindung dar, bei dem eine in Fig.16 schematisch dargestellte Steckachse unter Verwendung des in Fig.17 dargestellten Impedanzschaltkreises abgetastet wird.

Fig. 18 und 19 zeigen ein exzentrisches Werkstück 540, beispielsweise einen Nocken einer Nockenwelle, der im Inneren des Induktors oder der Spule 30 gedreht wird. Mit der Erfindung erzeugt ein Kennwert der Spulenüberwachungsvorrichtung ein Ausgangssignal, wie es in Fig.19 dargestellt ist. Dieses oszillierende Ausgangssignal entsteht dadurch, daß die Spitze des Nockens am Fischschwanzbereich vorbeigeht. Dieser Vorbeigang tritt periodisch auf und verändert das Impedanzsignal immer dann, wenn die Spitze des Nockens sich in der Nähe des Fischschwanzes befindet. Die Kurve nach Fig.19 kann dazu verwendet werden, die Spulenleistung zu modulieren, wenn das Werkstück gedreht wird. Es ist damit auch möglich, die Leistung bei der Rotation in Form von Impulsen aufzubringen, d.h. die Leistung pulsieren zu lassen. Das gleiche Verfahren kann auch dazu verwendet werden, die Exzentrizität und unausgeglichene Zustände des Werkstücks festzustellen, das im Inneren der Spule 30 gedreht wird. Mit diesem Merkmal der Erfindung kann vermieden werden, daß die Spitze des Nockens 540 beim Drehen im Inneren des Konduktors 30 überhitzt wird.

Fig.20-22 betreffen die Verwendung der Erfindung für die Kennsignalanalyse. In Fig.20 ist der Verlauf oder Graph des Phasenwinkelcosinus als gestrichelte Linie dargestellt. Die durchgezogenen Linien stellen - aufgetragen über der Zeit - den Verlauf des gewünschten Kennungssignals für das Werkstück dar. Wenn die gestrichelte Linie eine der durchgezogenen Linien kreuzt, wird das Werkstück als Ausschuß ausgeschieden. Dieser in Fig.20 gezeigte Verlauf oder Graph kann mit Hilfe des Aufzeichnungsmechanismus 114 aufgezeichnet und/oder mittels der Anzeigevorrichtung 112 angezeigt werden.

Fig.21 zeigt eine zusammengesetzte Kennsignal-Analyseanordnung. In dieser Anordnung wird das in Leitung 520a anliegende Impedanzsignal Z, das vom Ausgang des Kontrollblocks 520 (Fig.17) kommt, in einem Schaltblock 550 mit dem in Leitung 190a anliegenden Wert multipliziert und der so neu gewonnene Wert einer Kennsignal-Analysevorrichtung oder -anordnung 552 zugeführt. Wenn das Profil, das Produkt aus zwei Kennwerten wie beispielsweise Impedanz und Phasenwinkel ist, das als durchgezogene Linien dargestellte Kennsignal oder der Sollwertbereich in der Kennsignal-Analysevorrichtung 552 über- oder unterschreitet, kreuzt der gestrichelt dargestellte Profilverlauf eine der als durchgezogene Linien dargestellten Begrenzungen des Kennungssignals und das Werkstück wird ausgestoßen. Das Befehlssignal zum Auswerfen des Werkstücks wird über die Leitung 552a ausgegeben. Der Kennsignalverlauf kann auch von einer geeigneten Aufzeichnungsvorrichtung aufgezeichnet werden, die hierzu Angaben über die Ausgangsleitung 552b erhält. Zum Steuern bzw. Regeln des Induktions-Heizzyklusses ist eine Ausgangsleitung 552c vorgesehen, die Daten weiterleitet, wie sie durch die gestrichelte Linie dargestellt sind.

Fig.22 zeigt eine Steueranordnung für zwei Signale, wobei ein Kennungssignal-Analysegerät 560 von einem einzelnen Kennwert wie beispielsweise der Impedanz Z gesteuert wird. Dieses Analysegerät gibt auf Leitung 560a ein Auswurfsignal aus, wenn die tatsächliche Impedanz nicht im Bereich des gewünschten Kennungssignals liegt. In gleicher Weise gibt es ein zweites Kennsignal-Analysegerät 562, das einen anderen Kennwert wie beispielsweise den Phasenwinkelcosinus Þ überwacht. Dieses zweite Gerät hat eine Ausgangsleitung 562a. Wenn über die Leitungen 560a oder 562a ein Signal ausgegeben wird, erzeugt ein nachgeschaltetes Tor (gate) 570 ein Ausgangssignal in einer Leitung 572. Dieses Torsignal zeigt an, daß einer der beiden überwachten Kennwerte außerhalb des gewünschten Kennungssignalbereiches liegt. Ähnlich wie oben bereits beschrieben wird der erste Kennwertverlauf von dem über Leitung 560b gesteuerten Aufzeichnugsgerät aufgezeichnet und das Verfahren über Leitung 560c gesteuert bzw. geregelt. Der andere überwachte Kennwert hat ein Signal in einer Leitung 562b zur Folge, womit der Kennwertverlauf im Heizbetrieb aufgezeichnet werden kann. Der Heizzyklus selbst kann mit Hilfe von Daten gesteuert oder geregelt werden, die über eine Leitung 562c ausgegeben werden. Bei Anwendung der beschriebenen Kennwertkontrolle oder Kennungssignal-Analyse kann ein Werkstück auf Abweichungen von einer gewünschten Kontur oder Profil überprüft werden. Darüberhinaus wird das jeweilige Verfahren mit dem Kennsignal-Analysegerät auf Echtzeitbasis aufgezeichnet und/oder eine interaktive Steuerung bzw. Regelung verwendet, wie dies in den Fig.20-22 und in Fig.10 dargestellt ist.

## Patentansprüche

1. Überwachungsvorrichtung für Spulen zum Erzeugen eines Stromsignales mit einer Spannung, die ein Maß für den momentanen Wechselstrom in der Induktionsheizspule darstellt, die mit einer Wechselstromquelle über zwei in geringem Abstand voneinander angeordnete, parallele Eingangsleitungen verbunden ist, die durch einen schmalen Spalt voneinander getrennt sind, in dem ein von dem in den parallelen Leitungen fließenden Strom erzeugte Flux fließt, wobei der Spalt einander gegenüberliegende, längliche Durchlässe für den Fluß bildet, **gekennzeichnet** durch eine Abtastwicklung (100) mit mehreren Windungen (100w), die mit Befestigungsmitteln (362,372) zwischen den beiden Eingangsleitern (32, 34) und oberhalb des einen Flußdurchlasses angeordnet ist, wobei der durch den Spalt (36) fließende Fluß die Windungen (100w) der Abtastwicklung (100) kreuzt und durch Mittel zum Erzeugen des Stromsignals durch die in der Abtastwicklung induzierte Spannung.

2. Überwachungsvorrichtung nach Anspruch 1, **dadurch gekennzeichnet,** daß der Spalt (36) zwischen den Leitungen (32,34) eine Breite von etwa 0,5 bis 2,54 mm (0,02-0,1 inch) aufweist.

3. Überwachungsvorrichtung nach Anspruch 1 oder 2, **dadurch gekennzeichnet,** daß die Leitungen (32,34) einen im wesentlichen rechteckigen Querschnitt aufweisen.

4. Überwachungsvorrichtung nach einem der Ansprüche 1 bis 3, **gekennzeichnet** durch Mittel (60) zum Erzeugen eines Spannungssignals mit einer Spannung, die die Momentanspannung in der Induktionsheizspule (30) anzeigt, wobei die das Spannungssignal erzeugenden Mittel (60) einen ersten Anschlußkontakt (42) zum Anschluß an den ersten Eingangsleiter (22) und einen zweiten Anschlußkontakt (44) zum Anschluß an den zweiten Eingangsleiter (20) aufweisen.

5. Überwachungsvorrichtung nach einem der Ansprüche 1 bis 4, **dadurch gekennzeichnet,** daß die Befestigungsmittel (362,372) an einem Trägergehäuse (340) angeordnet sind, das mit einem länglichen Aufnahmeschlitz (346) versehen ist, in den die Leitungen (32,34) mit dem dazwischen gebildeten Flußdurchlaß eingreifen.

6. Überwachungsvorrichtung nach einem der Ansprüche 1 bis 5, **gekennzeichnet** durch eine Skalierungseinrichtung, um das Stromsignal umgekehrt proportional in Abhängigkeit von der Frequenz zu verändern.

7. Überwachungsvorrichtung nach einem der Ansprüche 1 bis 6, **dadurch gekennzeichnet,** daß die Skalierungseinrichtung ein Low-Pass-Filter (102) mit einer Bandbreite ist, die wesentlich geringer ist als die Betriebsfrequenz der Induktionsheizspule (30).

8. Überwachungsvorrichtung nach Anspruch 7, **dadurch gekennzeichnet,** daß die Bandbreite kleiner als 1,0 kHz ist.

9. Überwachungsvorrichtung nach einem der Ansprüche 1 bis 8, **gekennzeichnet** durch eine Einrichtung (190) zum Erzeugen eines Phasenwinkelsignals (Þ), die erste Gleichrichtmittel (160) zum Gleichrichten des Stromsignals (V_{IA}) in einen ersten Gleichspannungspegel und zweite Gleichrichtmittel (162) zum Gleichrichten des Spannungssignals (V_{V}) in einen zweiten Gleichspannungspegel sowie eine Multipliziereinrichtung (170) aufweist, die den ersten und den zweiten Gleichspannungspegel zu einem Produkt miteinander verknüpft, und die eine Teilereinrichtung (180) aufweist, mit der die momentane Leistung der Spule (30) durch das Produkt geteilt wird.

10. Vorrichtung zum Feststellen von Änderungen der physikalischen Eigenschaften eines induktiv erwärmten Werkstücks, mit einer Überwachungsvorrichtung zum Erzeugen eines Stromsignals mit einer Spannung, die den momentanen Wechselstrom in einer Induktionsheizspule anzeigt, die zum Erwärmen des Werkstücks dient, und die mit einer Wechselstromversorgung über zwei im geringen Abstand voneinander angeordnete, parallele Eingangsleiter verbunden ist, zwischen denen sich ein enger Spalt befindet, der von dem Flux durchflossen wird, der von dem in der Eingangsleitungen fließenden Strom erzeugt wird, wobei der Spalt zwei einander gegenüberliegende, längliche Fluxdurchlässe bildet, **dadurch gekennzeichnet,** daß die Überwachungsvorrichtung eine Abtastwicklung (100) mit mehreren Windungen (100w) aufweist, die mit Befestigungsmitteln (362,372) zwischen den parallelen Leitungen (32,34) und oberhalb des einen Fluxdurchlasses so angeordnet ist, daß der durch den Spalt (36) fließende Fluß die Windungen (100w) der Abtastwicklung (100) kreuzt, und daß Mittel zum Erzeugen des Stromsignals durch die in der Abtastwicklung induzierte Spannung vorgesehen sind und daß eine Einrichtung zum Erwärmen des Werkstücks (WP) durch die Induktionsheizspule (30) in einem Heizzyklus mit einem von der Stromversorgungseinrichtung (12) durch die Spule (30) geleiteten Strom vorgesehen ist, und daß eine Vorrichtung zum Erzeugen eines zusammengesetzten Signals unter Verwendung des Stromsignals vorgesehen ist, und daß Anzeigemittel vorgesehen sind, die anzeigen, wenn das zusammengesetzte Signal sich in einem Maß verändert, das eine Änderung der physikalischen Eigenschaften des Werkstücks (WP) anzeigt.

11. Vorrichtung zum Feststellen von Abweichungen der Eigenschaften eines induktiv erwärmten, rotierenden Werkstücks, **gekennzeichnet** durch eine Überwachungsvorrichtung (CM) zum Erzeugen eines Stromsignals mit einer Spannung, die ein Maß für den momentanen Wechselstrom in einer Induktionsheizspule (30) ist, die zum Erwärmen des Werkstücks (WP) verwendet wird und die an eine Wechselstromversorgung (12) über zwei in geringem Abstand voneinander angeordnete, parallele Eingangsleiter (32,34) angeschlossen ist, die durch einen engen Spalt (36) voneinander getrennt sind, durch den ein von dem Wechselstrom in den Eingangsleitungen (32,34) erzeugter Flux (F) fließt und der zwei einander gegenüberliegende, längliche Fluxdurchlässe bildet, wobei die Überwachungsvorrichtung (CM) eine Abtastwicklung (100) mit mehreren Windungen aufweist, die mit Befestigungsmitteln (362,372) zwischen den beiden parallelen Leitungen (32,34) und überhalb des einen Fluxdurchlasses befestigt ist, wobei der durch den Spalt (36) durchtretende Flux (F) die Windungen der Abtastwicklung (100) kreuzt, und wobei die Überwachungsvorrichtung (CM) Mittel zum Erzeugen des Stromsignals durch die in der Abtastwicklung (100) induzierte Spannung aufweist und mit einer Einrichtung zum Erwärmen des Werkstücks (WP) durch die von dem Strom von der Stromversorgung durchflossene Induktionsheizspule (30) versehen ist, und eine Vorrichtung (150) aufweist, um mit Hilfe des Stromsignals ein Phasenwinkelsignal (Þ) zu erzeugen, und eine Detektionsvorrichtung (110) aufweist, um Änderungen des Phasenwinkelsignals festzustellen, während das Werkstück (WP) im Inneren der Spule (30) rotiert.

12. Kennungssignal-Analysevorrichtung zum Vergleichen von ausgewählten Kennwerten beim Induktionserhitzen eines Werkstücks mit einem bekannten Wert des jeweiligen ausgewählten Kennwerts während eines Heizzyklusses für das Werkstück, **gekennzeichnet** durch eine Überwachungsvorrichtung (CM) zum Erzeugen eines Stromsignals mit einer Spannung, die ein Maß für den momentanen, in einer Induktionsheizspule (30) fließenden Strom ist, die zum Erhitzen des Werkstücks (WP) dient und die mit einer Wechselstromversorgung (12,14) über zwei in geringem Abstand voneinander angeordnete, zueinander parallel verlaufende Eingangsleitungen (32,34) verbunden ist, die von einem engen Spalt (36) getrennt sind , durch den der von dem Wechselstrom in den Leitungen (32,34) erzeugte Flux (F) fließt und der einander gegenüberliegende, längliche Fluxdurchlässe aufweist, wobei die Überwachungsvorrichtung eine Abtastwicklung (100) mit mehreren Windungen aufweist, die mit Befestigungsmitteln (362,372) zwischen den beiden parallelen Leitungen (32,34) und oberhalb des einen Fluxdurchlasses befestigt ist, wobei der durch den Spalt (36) fließende Flux die Windungen der Abtastwicklung (100) kreuzt oder durch diese hindurchtritt, und wobei die Überwachungsvorrichtung Mittel zum Erzeugen eines Stromsignals durch die in der Spule (30) induzierte Spannung aufweist und eine Einrichtung hat, um das Werkstück mittels der Induktionsheizspule (30) induktiv zu erwärmen, und daß eine das Stromsignal nutzende Vorrichtung zum Erzeugen eines Ausgangssignals vorgesehen ist, das kennzeichnend für den ausgewählten Kennwert ist, und daR eine Komparatoreinrichtung (552 bzw. 560 bzw. 652) vorgesehen ist, um das Ausgangssignal während des Heizzyklusses mit den bekannten Werten zu vergleichen, und daR eine Aufzeichnungseinrichtung vorgesehen ist, um die verglichenen Werte aufzuzeichnen.

13. Kennungssignal-Analysevorrichtung zum Vergleichen von ausgewählten Kennwerten beim Induktionserhitzen eines Werkstücks mit einem bekannten Wert des jeweiligen ausgewählten Kennwerts während eines Heizzyklusses für das Werkstück, **gekennzeichnet** durch eine Überwachungsvorrichtung (CM) zum Erzeugen eines Stromsignals mit einer Spannung, die ein Maß für den momentanen, in einer Induktionsheizspule (30) fließenden Strom ist, die zum Erhitzen des Werkstücks (WP) dient und die mit einer Wechselstromversorgung (12,14) über zwei in geringem Abstand voneinander angeordnete, zueinander parallel verlaufende Eingangsleitungen (32,34) verbunden ist, die von einem engen Spalt (36) getrennt sind , durch den der von dem Wechselstrom in den Leitungen (32,34) erzeugte Flux (F) fließt und der einander gegenüberliegende, längliche Fluxdurchlässe aufweist, wobei die Überwachungsvorrichtung eine Abtastwicklung (100) mit mehreren Windungen aufweist, die mit Befestigungsmitteln (362,372) zwischen den beiden parallelen Leitungen (32,34) und oberhalb des einen Fluxdurchlasses befestigt ist, wobei der durch den Spalt (36) fließende Flux die Windungen der Abtastwicklung (100) kreuzt oder durch diese hindurchtritt, und wobei die Überwachungsvorrichtung Mittel zum Erzeugen eines Stromsignals durch die in der Spule (30) induzierte Spannung aufweist und eine Einrichtung hat, um das Werkstück mittels der Induktionsheizspule (30) induktiv zu erwärmen, und wobei eine das Stromsignal nutzende Vorrichtung zum Erzeugen eines Ausgangssignals vorgesehen ist, das kennzeichnend für den ausgewählten Kennwert ist, und wobei eine Komparatoreinrichtung vorgesehen ist, um das Ausgangssignal während des Heizzyklusses mit den bekannten Werten zu vergleichen, und wobei eine Detektionseinrichtung vorgesehen ist, um festzustellen, wenn das Ausgangssignal ein Nicht-Einhalten des Standardwertes anzeigt.

14. Abtastvorrichtung für ein längliches Werkstück aus Metall, **gekennzeichnet** durch
- eine Bewegungseinrichtung zum Bewegen einer Spule (30) entlang des Werkstücks;
- eine Fühleinrichtung zum Erzeugen eines Spannungssignals mit einer Spannung, die ein Maß für den momentanen Wechselstrom in der Spule (30) ist, wobei die Spule mit einer Wechselstromversorgung über zwei in geringem Abstand voneinander angeordnete, parallele Eingangsleitungen (32,34) verbunden ist, die von einem engen Spalt (36) getrennt sind, durch den der von dem Wechselstrom in den Leitungen (32,34) erzeugte Flux (F) fließt und der einander gegenüberliegende, längliche Fluxdurchlässe bildet;
- eine an der Fühleinrichtung angeordnete Abtastwicklung (100) mit mehreren Windungen, die mit Befestigungsmitteln (362,372) an der Fühleinrichtung zwischen den parallelen Leitungen (32,34) und in einer einen der Fluxdurchlässe überdeckenden Lage so angeordnet ist, daß der durch den Spalt (36) fließende Flux die Windungen der Abtastwicklung (100) kreuzt bzw. durch diese hindurchtritt;
- Mittel zum Erzeugen des Stromsignals durch die in der Abtastwicklung (100) induzierte Spannung; und
- Mittel zum Erzeugen eines Kennwert-Anzeigesignals als Antwort auf das Stromsignal.

15. Überwachungsvorrichtung zum Erzeugen eines Strom-Spannungs-Signals, das ein Maß für den momentanen Wechselstrom in einer Induktionsheizspule ist, die mit einer Wechselstromversorgung über zwei in geringem Abstand voneinander angeordnete, parallele Eingangsleitungen verbunden ist, die von einem engen Spalt getrennt sind, durch den der von dem in den Leitungen fließenden Wechselstrom erzeugte Flux fließt, und der einander gegenüberliegende, längliche Fluxdurchlässe bildet, **gekennzeichnet** durch
- Abtastmittel zum Abtasten der zeitlichen Änderung des Fluxes;
- Signalerzeugungsmittel, die auf die Abtastmittel ansprechen, um ein Spannungssignal abhängig von der Größe der Wechselstromfrequenz zu erzeugen;
- eine Einrichtung, um die Frequenzfunktion von dem Spannungssignal abzutrennen, um ein neues Spannungssignal zu erzeugen, das eine Funktion der Stromstärke darstellt; und
- Mittel zur Verwendung des neuen Spannungssignals als Maß für die Stromstärke in der Induktionsheizspule (30).
